# EUROPEAN PATENT APPLICATION

(11) **EP 4 819 781 A1**
(43) Date of publication of application: **07.10.2026**
(21) Application number: 25888065.7
(22) Date of filing: 25.10.2025
(51) Int. Cl.: H05K 7/20

(54) **VAPOR CHAMBER AND ELECTRONIC DEVICE**

(30) Priority: 07.11.2024 CN 202411593370
(71) Applicant: Huawei Technologies Co., Ltd., Shenzhen, Guangdong 518129 (CN)
(72) Inventor: LUO, Yang, Shenzhen, Guangdong 518129 (CN); CHEN, Qiu, Shenzhen, Guangdong 518129 (CN); LIU, Yonglu, Shenzhen, Guangdong 518129 (CN); HU, Jinyan, Shenzhen, Guangdong 518129 (CN); JIN, Linfang, Shenzhen, Guangdong 518129 (CN)
(74) Representative: Körber, Martin Hans
(86) International application number: PCT/CN2025/130018
(87) International publication number: WO 2026/098257

(57) **Abstract**

Embodiments of this application provide a vapor chamber and an electronic device. The vapor chamber includes a first cover plate, a second cover plate, and a capillary layer. The first cover plate and the second cover plate are stacked, the first cover plate and the second cover plate are connected, the first cover plate and the second cover plate enclose a cavity, and the capillary layer is located in the cavity. The second cover plate includes a first metal layer and a first polymer material layer, the first metal layer and the first polymer material layer are stacked, the first metal layer is connected between the first polymer material layer and the first cover plate, and a surface roughness Rz of a surface that is of the first metal layer and that is connected to the first polymer material layer ∈ [0.5 µm, 5 µm]. Solutions in embodiments of this application can improve a manufacturing yield of the vapor chamber, so that the vapor chamber has good structural reliability and working performance.

## Description

This application claims priority to Chinese Patent Application No. 202411593370.0, filed with the China National Intellectual Property Administration on November 7, 2024, entitled "VAPOR CHAMBER AND ELECTRONIC DEVICE" which is incorporated herein by reference in its entirety.

### TECHNICAL FIELD

This application relates to the field of heat dissipation technologies, and in particular, to a vapor chamber and an electronic device.

### BACKGROUND

A vapor chamber (vapor chamber, VC) is built in an electronic device like a mobile phone, a computer, or a server. A working fluid in the vapor chamber can perform two-phase circulation, to spread heat of a heat source to a larger area, avoid an excessive high temperature due to heat accumulated in a local region, and improve working reliability and performance of the electronic device. However, a conventional vapor chamber has poor producibility, and manufacturing defects, for example, structural delamination and blistering on a surface of the vapor chamber, are prone to occur. As a result, a structure of the vapor chamber is unreliable, affecting working performance of the vapor chamber.

### SUMMARY

Embodiments of this application provide a vapor chamber and an electronic device, to improve a manufacturing yield of the vapor chamber, so that the vapor chamber has good structural reliability and working performance.

According to a first aspect, an embodiment of this application provides a vapor chamber, including a first cover plate, a second cover plate, and a capillary layer. The first cover plate and the second cover plate are stacked, the first cover plate and the second cover plate are connected, the first cover plate and the second cover plate enclose a cavity, and the capillary layer is located in the cavity. The second cover plate includes a first metal layer and a first polymer material layer, the first metal layer and the first polymer material layer are stacked, the first metal layer is connected between the first polymer material layer and the first cover plate, and a surface roughness Rz of a surface that is of the first metal layer and that is connected to the first polymer material layer ∈ [0.5 µm, 5 µm]. In this embodiment of this application, an area of the first cover plate may be basically the same as an area of the second cover plate, and a periphery of the first cover plate may be connected to a periphery of the second cover plate. Alternatively, one of the first cover plate and the second cover plate has a larger area, and the other has a smaller area; and the cover plate with the smaller area may be located within a boundary of the cover plate with the larger area, and a periphery of the cover plate with the smaller area may be connected to the cover plate with the larger area.

In this embodiment of this application, the surface roughness of the surface that is of the first metal layer and that is connected to the first polymer material layer is set to be within the foregoing range, so that the surface that is of the first metal layer and that is bonded with the first polymer material layer can be smooth. This can significantly reduce a void on a micro interface between the first metal layer and the first polymer material layer, enhance tightness of bonding between the first metal layer and the first polymer material layer, resolve blistering on a surface of the vapor chamber and delamination between the metal layer and the polymer material layer that are caused by gas expansion in a void in a local high-temperature process in manufacturing of the vapor chamber, and improve a manufacturing yield of the vapor chamber, so that the vapor chamber has good structural reliability and working performance.

In this embodiment of this application, the second cover plate is produced by using a composite material, so that advantages of a metal material and a polymer material can be combined, and the second cover plate not only has good heat conductance and strength, but also has good flexibility and a light weight.

In an implementation of the first aspect, the capillary layer is integrated with the first metal layer. Being integrated means that the capillary layer and the first metal layer are not assembled via a mechanical component (for example, a connector like a screw, a rivet, or a buckle, or a connection medium like an adhesive). There is no obvious interface gap at a joint between the capillary layer and the first metal layer, and both present a continuous or fused state.

For example, the capillary layer is formed on the first metal layer by using a surface processing and forming process, and the capillary layer is a part of the first metal layer. The surface processing and forming process includes but is not limited to etching, laser engraving, electroplating, or 3D printing. For example, the capillary layer is soldered to the first metal layer.

The capillary layer is integrated with the first metal layer, so that the capillary layer and the first metal layer can be fully bonded, and an air gap between the capillary layer and the first metal layer can be reduced. This helps improve uniform temperature heat dissipation performance of the vapor chamber. In addition, a mechanical component can be avoided to connect the capillary layer and the first metal layer, to implement lightness and thinness of the vapor chamber.

In an implementation of the first aspect, the capillary layer includes a capillary through-hole layer and a plurality of support bodies, and the plurality of support bodies are connected between the capillary through-hole layer and the first metal layer; and a plurality of capillary through-holes are disposed on the capillary through-hole layer, the plurality of capillary through-holes have a first capillary through-hole, a channel is formed between any two adjacent support bodies, and at least a part of a projection of the first capillary through-hole in a thickness direction of the capillary through-hole layer falls between the two adjacent support bodies.

In this implementation, the first metal layer may be a flat layer structure. The plurality of support bodies and the capillary through-hole layer may be formed on the first metal layer. The support body is configured to support the capillary through-hole layer and form a flow channel of a working fluid. The capillary through-hole on the capillary through-hole layer is in communication with the channel, and the capillary through-hole is configured to provide a capillary force, so that the working fluid can flow into the capillary through-hole from the channel. In this implementation, a gas-liquid channel in the capillary layer can be designed, to improve heat conduction performance of the vapor chamber, increase a maximum heat transfer amount Qmax of the vapor chamber, and reduce a weight of the vapor chamber. This helps improve a heat dissipation capability of the electronic device, increase maximum main frequency duration of a chip in the electronic device, and help implement lightness and thinness of the entire device.

In an implementation of the first aspect, the first polymer material layer includes a first base layer and a plurality of first protrusion parts, and the plurality of first protrusion parts are all protruded on a side that is of the first base layer and that faces the first cover plate; and the first metal layer covers the first base layer, and each support body wraps one of the first protrusion parts.

In this implementation, it may be considered that each support body and the protrusion part wrapped by the support body jointly form a support pillar structure. The support body and the protrusion part wrapped by the support body jointly form one support pillar structure, and the protrusion part is produced by using a light polymer material. Therefore, the support pillar structure is light, and helps reduce a weight of the vapor chamber. In addition, this structure has high processing precision, and can ensure structural precision of the vapor chamber.

In an implementation of the first aspect, a plurality of first recess parts are disposed on a side that is of the second cover plate and that is away from the first cover plate, each first recess part recesses toward the first cover plate, a part that is of the first metal layer and that is located in each first recess part serves as one support body, a channel is formed between any two adjacent support bodies, and each support body is connected to the capillary layer; and a plurality of capillary through-holes are disposed on the capillary layer, the plurality of capillary through-holes have a first capillary through-hole, and at least a part of a projection of the first capillary through-hole in a thickness direction of the capillary layer falls between the two adjacent support bodies.

In this implementation, the first metal layer may be used to form the support body. Therefore, a thickness and a weight of the second cover plate can be reduced. In addition, the second cover plate has high processing precision, and can ensure structural precision of the vapor chamber.

In an implementation of the first aspect, each first recess part is filled with a thermally conductive material. The thermally conductive material has good thermally conductive performance, and includes but is not limited to a thermally conductive adhesive including a graphene component, or a phase change material (phase change material, PCM). The thermally conductive material is used to discharge air (the air is a poor heat conductor) in the recess part, to enhance heat conduction between the second cover plate and a heat source.

In an implementation of the first aspect, the plurality of capillary through-holes include a plurality of groups sequentially arranged in a first direction, each group includes at least two capillary through-holes sequentially arranged in a second direction, and the first direction intersects the second direction; and for any two adjacent groups, in the second direction, at least one capillary through-hole in another group is distributed between every two adjacent capillary through-holes in one group.

In this implementation, arrangement of the capillary through-holes may be referred to as cross arrangement. Compared with matrix arrangement or checkerboard arrangement, cross arrangement can increase density and a quantity of capillary through-holes in the capillary layer when an area of the capillary layer is specific, so that more parts of the capillary layer can provide capillary forces, and the liquid working fluid can continuously receive the capillary force in a flow process, thereby increasing a fluid replenishment and return speed, and helping improve heat conduction and heat dissipation efficiency.

In an implementation of the first aspect, opening areas of at least two capillary through-holes in the plurality of capillary through-holes are different from each other.

In this implementation, positions with smaller opening areas may be closer to the heat source, and capillary forces of capillary through-holes in these positions are larger, so that quick fluid replenishment and return of the working fluid can be implemented, thereby facilitating quick heat conduction and heat dissipation in a high-temperature region. Positions with larger opening areas may be farther away from the heat source, and flow resistance in these positions is smaller, so that a condensed working fluid can easily flow through the capillary through-holes and return to the channels between the support bodies, thereby helping improve a return speed and further improving heat conduction and heat dissipation efficiency. In this implementation, for example, the opening areas of the capillary through-holes may be in an increasing trend.

In an implementation of the first aspect, at least one support body of the plurality of support bodies is of a columnar structure or a strip-shaped structure.

In this implementation, the support bodies are made into the columnar structures, so that the support bodies are dotted, and a channel network is formed between the support bodies. When the vapor chamber works, after a working fluid in a position in the channel network evaporates, liquid working fluids in a plurality of surrounding positions may replenish the working fluid in the position. In this design, the vapor chamber is insensitive to a position of the heat source, and the vapor chamber can correspond to a plurality of heat sources to conduct heat and dissipate heat for the plurality of heat sources. Alternatively, a position of the vapor chamber can be fastened, and a position of the heat source can be adjusted as required, so that the vapor chamber can always properly conduct heat and dissipate heat. In addition, this can alleviate a defect that a temperature in the position increases excessively because the working fluid is evaporated at the position and the liquid working fluid cannot be replenished, and reduce a phenomenon that a flow of the working fluid is unstable during boiling and evaporation.

In this implementation, the support bodies are made into the strip-shaped structures. Widths of the channels between the adjacent support bodies are basically constant. Therefore, the liquid working fluid in the channel has strong flow directivity and small flow resistance, so that the liquid working fluid can quickly replenish a liquid working fluid in an evaporation position, thereby ensuring heat conduction and heat dissipation effect.

In an implementation of the first aspect, a plurality of first support bodies are disposed on the plurality of support bodies, the plurality of first support bodies are sequentially arranged in the first direction, each first support body is of a strip-shaped structure extending in the second direction, and the first direction intersects the second direction.

In this implementation, at least a part of the support bodies are made into the strip-shaped structures. Widths of channels between adjacent first support bodies are basically constant. Therefore, a liquid working fluid in the channel has strong flow directivity and small flow resistance, so that the liquid working fluid can quickly replenish a liquid working fluid in an evaporation position, thereby ensuring heat conduction and heat dissipation effect.

In an implementation of the first aspect, the plurality of first support bodies include a first group and a second group, the first group and the second group are adjacent and arranged in the first direction, and each of the first group and the second group includes at least two first support bodies sequentially arranged in the second direction; and a projection of a gap between any two adjacent first support bodies in the first group in the first direction falls on one first support body in the second group.

In this implementation, cross arrangement may be used for the first support bodies of the strip-shaped structures, and a channel extending in the second direction between the first support bodies may be referred to as a groove. Because the groove is formed, the liquid working fluid in the groove has strong flow directivity and small flow resistance, so that the liquid working fluid can quickly replenish a liquid working fluid in an evaporation position, thereby ensuring heat conduction and heat dissipation effect. In addition, a gap may be formed between adjacent support bodies in each group, and the gap is in communication with the groove, to form a channel network that communicates in upward, downward, leftward, and rightward directions. When the vapor chamber works, after a working fluid in a position in the channel network evaporates, liquid working fluids in a plurality of surrounding positions may replenish the working fluid in the position. Therefore, the vapor chamber is insensitive to a position of the heat source, and the vapor chamber can correspond to a plurality of heat sources to conduct heat and dissipate heat for the plurality of heat sources. Alternatively, a position of the vapor chamber can be fastened, and a position of the heat source can be adjusted as required, so that the vapor chamber can always properly conduct heat and dissipate heat. In addition, this can alleviate a defect that a temperature in the position increases excessively because the working fluid is vaporized and evaporated at the position and then the liquid working fluid cannot be replenished, and reduce a phenomenon that a flow of the working fluid is unstable during boiling and evaporation. In addition, the gap between the adjacent support bodies in each group is small, and the gap may be less than the width of the groove between the adjacent support bodies. The gap may provide a specific capillary force. This helps improve fluidity of a liquid working fluid, ensure quick replenishment of the liquid working fluid, and improve heat conduction and heat dissipation effect.

In an implementation of the first aspect, the second cover plate further includes a second metal layer, the first metal layer, the first polymer material layer, and the second metal layer are sequentially stacked, the second metal layer is connected to the first polymer material layer, and a surface roughness Rz of a surface that is of the second metal layer and that is connected to the first polymer material layer ∈ [0.5 µm, 5 µm].

In this implementation, the second metal layer can be added, to increase structural strength and rigidity of the second cover plate, and improve mechanical performance of the second cover plate. In this implementation, the second cover plate is produced by using a composite material, so that advantages of a metal material and a polymer material can be combined, and the second cover plate not only has good heat conductance and strength, but also has good flexibility and a light weight. The surface roughness of the surface that is of the second metal layer and that is connected to the first polymer material layer is set to be within the foregoing range, so that the surface that is of the second metal layer and that is bonded with the first polymer material layer can be smooth. This can significantly reduce a void on a micro interface between the second metal layer and the first polymer material layer, enhance tightness of bonding between the second metal layer and the first polymer material layer, resolve blistering on a surface of the vapor chamber and delamination between the metal layer and the polymer material layer that are caused by gas expansion in a void in a local high-temperature process in manufacturing of the vapor chamber, and improve a manufacturing yield of the vapor chamber, so that the vapor chamber has good structural reliability and working performance.

In an implementation of the first aspect, the first cover plate includes a working region, and the working region participates in enclosing the cavity; and the working region includes a plurality of second protrusion parts and a plurality of second recess parts, the plurality of second protrusion parts and the plurality of second recess parts are staggered, and a plurality of second protrusion parts are disposed around each second recess part; each second protrusion part protrudes in a direction away from the second cover plate; and each second recess part recesses toward the second cover plate and is connected to the capillary layer.

In this implementation, the first cover plate may be of an equal thickness structure. The first cover plate is formed into a structure with alternating protrusion and recess parts, and a support pillar of the vapor chamber can be produced on the first cover plate, to ensure rigidity and strength of the vapor chamber, and improve mechanical performance of the vapor chamber.

In an implementation of the first aspect, the first cover plate includes a working region, and the working region participates in enclosing the cavity; and the working region includes a second base layer and a plurality of third protrusion parts, and the plurality of third protrusion parts are all protruded on a side that is of the second base layer and that faces the second cover plate, and are all connected to the capillary layer.

In this implementation, the first cover plate may be of an unequal thickness structure. The protrusion part is formed on the first cover plate, and a support pillar of the vapor chamber can be produced on the first cover plate, to ensure rigidity and strength of the vapor chamber, and improve mechanical performance of the vapor chamber.

In an implementation of the first aspect, the first cover plate includes a third metal layer, and the third metal layer is connected to the first metal layer.

In this implementation, the third metal layer may be made of a single material or a metal-metal composite material. This type of first cover plate has low costs and good mechanical performance.

In an implementation of the first aspect, the first cover plate further includes a second polymer material layer connected to the third metal layer, the second polymer material layer, the third metal layer, and the first metal layer are sequentially stacked, and a surface roughness Rz of a surface that is of the third metal layer and that is connected to the second polymer material layer ∈ [0.5 µm, 5 µm].

In this implementation, the first cover plate is produced by using a composite material, so that advantages of a metal material and a polymer material can be combined, and the first cover plate not only has good heat conductance and strength, but also has good flexibility and a light weight. The surface roughness of the surface that is of the third metal layer and that is connected to the second polymer material layer is set to be within the foregoing range, so that the surface that is of the third metal layer and that is bonded with the second polymer material layer can be smooth. This can significantly reduce a void on a micro interface between the third metal layer and the second polymer material layer, enhance tightness of bonding between the third metal layer and the second polymer material layer, resolve blistering on a surface of the vapor chamber and delamination between the metal layer and the polymer material layer that are caused by gas expansion in a void in a local high-temperature process in manufacturing of the vapor chamber, and improve a manufacturing yield of the vapor chamber, so that the vapor chamber has good structural reliability and working performance.

In an implementation of the first aspect, the first cover plate further includes a fourth metal layer, the fourth metal layer, the second polymer material layer, and the third metal layer are sequentially stacked, the fourth metal layer is connected to the second polymer material layer, and a surface roughness Rz of a surface that is of the fourth metal layer and that is connected to the second polymer material layer ∈ [0.5 µm, 5 µm].

In this implementation, the fourth metal layer can be added, to increase structural strength and rigidity of the first cover plate, and improve mechanical performance of the first cover plate. The surface roughness of the surface that is of the fourth metal layer and that is connected to the second polymer material layer is set to be within the foregoing range, so that the surface that is of the fourth metal layer and that is bonded with the second polymer material layer can be smooth. This can significantly reduce a void on a micro interface between the fourth metal layer and the second polymer material layer, enhance tightness of bonding between the fourth metal layer and the second polymer material layer, resolve blistering on a surface of the vapor chamber and delamination between the metal layer and the polymer material layer that are caused by gas expansion in a void in a local high-temperature process in manufacturing of the vapor chamber, and improve a manufacturing yield of the vapor chamber, so that the vapor chamber has good structural reliability and working performance.

In an implementation of the first aspect, a material of the polymer material layer in the vapor chamber includes polyimide, polypropylene, polytetrafluoroethylene, polyethylene terephthalate, polyethylene naphthalate, polydimethylsiloxane, polyethylene, polypropylene carbonate, polyvinyl chloride, polyvinylidene chloride, polystyrene, or polyamide. The foregoing material is a polymer material, and the foregoing polymer material has reliable performance and is easy for mass production. The polymer material layer is the first polymer material layer or the second polymer material layer in the foregoing implementations.

In an implementation of the first aspect, a glass transition temperature of the polymer material layer in the vapor chamber is greater than or equal to 320°C. The polymer material layer is the first polymer material layer or the second polymer material layer in the foregoing implementations. The glass temperature is also referred to as a glass transition temperature, and is usually represented by Tg. The glass temperature is a temperature at which a high polymer changes from a highly elastic state to a glass state. The glass temperature of the polymer material layer is set to be within the foregoing large range, so that the polymer material layer can have good high-temperature resistance, and the polymer material layer can maintain stable performance in a local high-temperature process (for example, soldering the first cover plate and the second cover plate, and producing the capillary layer at a high temperature of more than 300°C) in manufacturing of the vapor chamber. This helps improve a manufacturing yield of the vapor chamber, so that the vapor chamber has good structural reliability and working performance.

According to a second aspect, an embodiment of this application provides an electronic device, including a housing and a vapor chamber, where the vapor chamber is located in the housing. The vapor chamber in the electronic device in this embodiment of this application has good structural reliability and working performance, can improve a heat dissipation capability of the electronic device, increase maximum main frequency duration of a chip in the electronic device, and help implement lightness and thinness of the entire device.

In an implementation of the second aspect, the electronic device further includes a display. The display is disposed on the housing and encloses an accommodation space with the housing, and the vapor chamber is located in the accommodation space.

In this implementation, the vapor chamber may be connected to the display, so that the vapor chamber can avoid a component below the vapor chamber, and the vapor chamber can have a larger area, thereby improving heat conduction effect of the vapor chamber. Alternatively, the vapor chamber may be connected to the housing as required.

### BRIEF DESCRIPTION OF DRAWINGS

FIG. 1 is a diagram of an assembly structure of an electronic device according to an embodiment of this application;
FIG. 2 is a diagram of a disassembled structure of the electronic device in FIG. 1;
FIG. 3 is a diagram of a cross-sectional structure at A-A in FIG. 1;
FIG. 4 is a diagram of a side sectional structure of a vapor chamber according to an embodiment;
FIG. 5 is a diagram of a side sectional structure of a second cover plate of the vapor chamber in FIG. 4;
FIG. 6 is a diagram of a structure of a bonding interface between a first metal layer and a first polymer material layer in a second cover plate;
FIG. 7 is a diagram of a side sectional structure of a first cover plate of the vapor chamber in FIG. 4;
Each of FIG. 8 and FIG. 9 is a diagram of a blistering anomaly caused by a local high-temperature process;
FIG. 10 is a diagram of a structural delamination anomaly caused by a local high-temperature process;
FIG. 11 is a diagram of another side sectional structure of a first cover plate;
FIG. 12 is a diagram of a connection structure between a capillary layer and a second cover plate in a vapor chamber;
FIG. 13 is a diagram of a side sectional structure of a capillary layer;
FIG. 14 is a diagram of a three-dimensional structure of a capillary layer;
FIG. 15 is a diagram of a partial top-view structure of a capillary through-hole layer in the capillary layer in FIG. 14;
FIG. 16 is a diagram of another partial top-view structure of a capillary through-hole layer;
FIG. 17 is a diagram of another partial top-view structure of a capillary through-hole layer;
FIG. 18 is a diagram of another partial top-view structure of a capillary through-hole layer;
FIG. 19 is a diagram of a partial top-view structure of support bodies in a capillary layer in FIG. 14;
FIG. 20 is a diagram of another partial top-view structure of support bodies;
FIG. 21 is a diagram of another partial top-view structure of support bodies;
FIG. 22 is a diagram of a three-dimensional arrangement structure of a support body;
FIG. 23 is a diagram of another three-dimensional arrangement structure of support bodies;
FIG. 24 is a diagram of a top-view arrangement structure of the support bodies in FIG. 23;
FIG. 25 to FIG. 28 show position relationships between capillary through-holes and support bodies in several implementations at a top-view angle;
FIG. 29 is a diagram of a connection structure between a capillary layer and a second cover plate in another embodiment;
FIG. 30 is a diagram of a connection structure between a capillary layer and a second cover plate in another embodiment;
FIG. 31 is a diagram of a connection structure between a capillary layer and a second cover plate in another embodiment;
FIG. 32 is a diagram of a side sectional structure of a vapor chamber in another embodiment;
FIG. 33 is a diagram of a side sectional structure of a first cover plate in an embodiment;
FIG. 34 is a diagram of a side sectional structure of a vapor chamber in another embodiment;
FIG. 35 is a diagram of a side sectional structure of a vapor chamber in another embodiment;
FIG. 36 is a diagram of a side sectional structure of a first cover plate in another embodiment;
FIG. 37 is a diagram of a side sectional structure of a first cover plate in another embodiment;
FIG. 38 is a diagram of a side sectional structure of a first cover plate in another embodiment; and
FIG. 39 is a diagram of a side sectional structure of a first cover plate in another embodiment.

### DESCRIPTION OF EMBODIMENTS

Embodiments of this application provide an electronic device and a vapor chamber in the electronic device. The electronic device includes but is not limited to a mobile phone (for example, a bar phone or a foldable phone), a notebook computer, a tablet computer, a desktop computer, a vehicle-mounted device, a wearable device, a smart speaker, a smart screen, a server, a network device (for example, a switch or a router), a communication device (for example, a base station or a data center), an LED lamp, or an industrial production device.

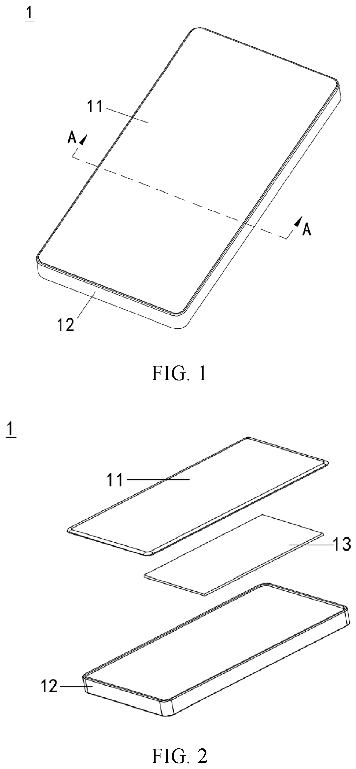

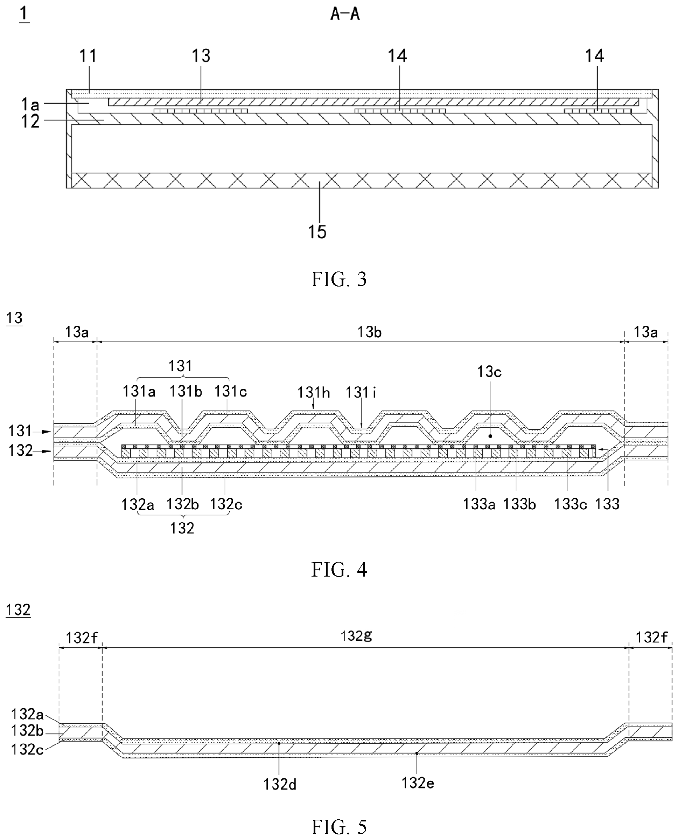

FIG. 1 shows a three-dimensional structure of an electronic device 1. FIG. 2 is a diagram of a disassembled structure of the electronic device 1 in FIG. 1. FIG. 3 is a diagram of a cross-sectional structure at A-A in FIG. 1.

As shown in FIG. 1 and FIG. 2, the electronic device 1 may be, for example, a mobile phone. The electronic device 1 may include a display 11, a housing 12, a vapor chamber 13, and the like.

The housing 12 may be an assembly assembled from several components, or may be a single component. For example, the housing 12 may be a middle frame. As shown in FIG. 1 to FIG. 3, the display 11 is mounted on one side of the housing 12, and the display 11 and the housing 12 may enclose an accommodation space 1a. Several components 14 may be arranged in the accommodation space 1a, and the components 14 may be mechanical components or electronic devices. As shown in FIG. 3, the electronic device 1 may further include a housing 15, the housing 15 is connected to the housing 12, and the housing 15 and the display 11 are located on opposite sides of the housing 12. For example, the housing 15 may be a rear housing. The housing 15 and the housing 12 may enclose the accommodation space 1a, and several electronic devices may be disposed in the accommodation space 1a, including but not limited to a circuit board, a battery, a loudspeaker, a rear-facing camera, and the like.

A part of electronic devices in the electronic device 1 are heat sources. A heat source is a single device that has a specific function and can generate heat during operation, or an assembly or a module including several single devices. The heat source includes but is not limited to a camera assembly, a sensor, a system on chip (system on chip, SOC), a charging module (Charge IC), a battery, a system in package (system in package, SIP) module, a loudspeaker module, or a circuit board assembly.

As shown in FIG. 3, the vapor chamber 13 may be located in the accommodation space 1a. For example, the vapor chamber 13 may be connected to the display 11, so that the vapor chamber 13 can avoid a component 14 below the vapor chamber, and the vapor chamber 13 can have a larger area, thereby improving heat conduction effect of the vapor chamber 13. Alternatively, the vapor chamber 13 may be connected to the housing 12 as required.

It may be understood that the vapor chamber 13 is arranged near the heat source. For example, the heat source may not be connected to the vapor chamber 13, and another component (not a thermal interface material) is disposed between the heat source and the vapor chamber 13. The heat source and the vapor chamber 13 conduct heat via the another component. For example, as shown in FIG. 3, an electronic device in the accommodation space 1a serves as a heat source, and the electronic device is separated from the vapor chamber 13 by the housing 12 (for example, a middle plate of a middle frame). The electronic device and the vapor chamber 13 conduct heat via the housing 12. Alternatively, the heat source may be connected to the vapor chamber 13, for example, by using a thermal interface material. For example, refer to FIG. 3, a through-hole may be disposed on a middle plate, and an electronic device in the accommodation space 1a may be connected to the vapor chamber 13 in the accommodation space 1a via the through-hole.

It may be understood that the descriptions of a position and an external structure of the vapor chamber 13 and a quantity of vapor chambers 13 in the foregoing are merely examples, and are not limited in embodiments of this application. For example, the vapor chamber 13 may be disposed at any position in a housing of the electronic device 1, and is not limited to the accommodation space 1a.

The following describes in detail a structure of the vapor chamber 13 in embodiments of this application.

FIG. 4 shows a partial side sectional structure of the vapor chamber 13 in Embodiment 1.

As shown in FIG. 4, the vapor chamber 13 may include a first cover plate 131, a second cover plate 132, and a capillary layer 133. Both the first cover plate 131 and the second cover plate 132 may be approximately of a plate-shaped structure, and may be stacked, that is, the first cover plate 131 and the second cover plate 132 are arranged in a thickness direction of the first cover plate 131 and the second cover plate 132. A periphery of the first cover plate 131 and a periphery of the second cover plate 132 are connected together, and form a periphery 13a of the vapor chamber 13. The periphery 13a may be referred to as a connection region 13a. A middle part of the first cover plate 131 protrudes relative to the periphery of the first cover plate 131, a middle part of the second cover plate 132 protrudes relative to the periphery of the second cover plate 132, and both the middle part of the first cover plate 131 and the middle part of the second cover plate 132 may protrude in a direction away from each other, and enclose a cavity 13c. The middle part of the first cover plate 131 and the middle part of the second cover plate 132 may form a middle part 13b of the vapor chamber 13, and the middle part 13b may be referred to as a working region 13b. It may be understood that the connection region 13a surrounds an outer periphery of the working region 13b. The capillary layer 133 is located in the cavity 13c, or in other words, located in the working region 13b.

The cavity 13c may be filled with a working fluid, and the working fluid includes but is not limited to water, acetone, ethanol, or methanol. The working fluid may conduct heat through two-phase change (that is, conversion between a liquid phase and a gas phase through evaporation and condensation).

In Embodiment 1, the second cover plate 132 may face the heat source, and the first cover plate 131 may be away from the heat source. With reference to FIG. 3 and FIG. 4, for example, the first cover plate 131 may face the display 11, and the second cover plate 132 may be away from the display 11.

The following describes structures in the vapor chamber 13 one by one.

FIG. 5 shows the second cover plate 132 in FIG. 4. As shown in FIG. 5, the second cover plate 132 may include a first metal layer 132a, a first polymer material layer 132b, and a second metal layer 132c. The three layers are sequentially arranged in a thickness direction of the second cover plate 132, and the first polymer material layer 132b is connected to the first metal layer 132a and the second metal layer 132c. As shown in FIG. 4, the first metal layer 132a faces the first cover plate 131.

As shown in FIG. 5, the first metal layer 132a has a surface 132d facing the first polymer material layer 132b, and the surface 132d is connected to (or bonded with) the first polymer material layer 132b. A surface roughness Rz of the surface 132d ∈ [0.5 µm, 5 µm], for example, Rz may be 0.5 µm, 1.5 µm, 2 µm, or 5 µm. In embodiments of this application, the surface roughness Rz is defined according to a national standard. For example, the surface roughness Rz may represent a sum of a maximum peak height of profile and a maximum valley depth of profile within a sampling length. The sampling length is determined based on a range of the surface roughness Rz.

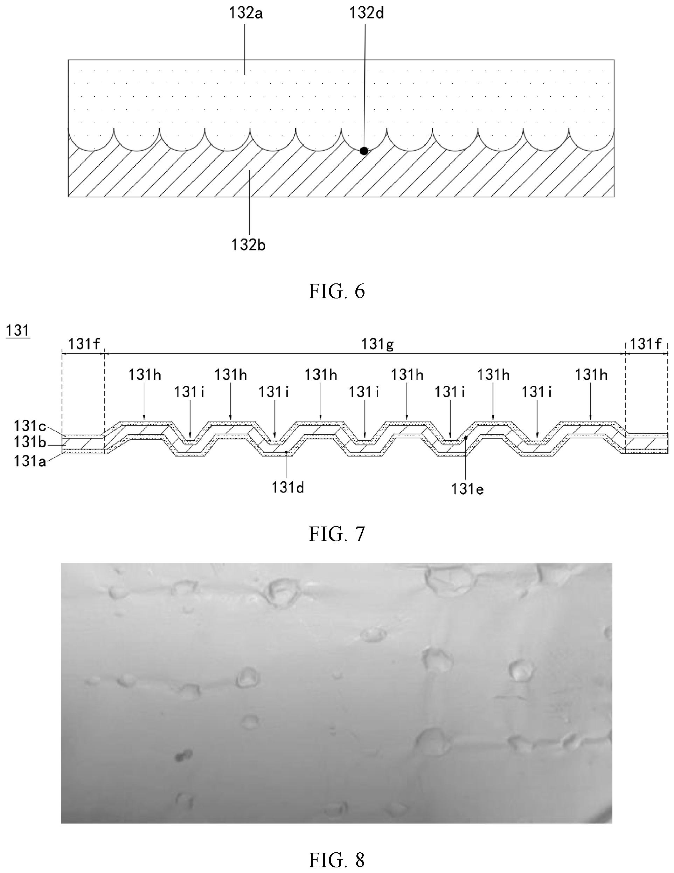

FIG. 6 shows a microstructure of the surface 132d of the first metal layer 132a, or shows a micro interface between the first metal layer 132a and the first polymer material layer 132b.

As shown in FIG. 5, the second metal layer 132c has a surface 132e facing the first polymer material layer 132b, and the surface 132e is connected to (or bonded with) the first polymer material layer 132b. A surface roughness Rz of the surface 132e ∈ [0.5 µm, 5 µm], for example, Rz may be 0.5 µm, 1.5 µm, 2 µm, or 5 µm.

In this embodiment, the surface roughness of at least one of the surface 132d and the surface 132e may be limited as described above.

In this embodiment of this application, for convenience, the first metal layer 132a, the second metal layer 132c, and a third metal layer 131a and a fourth metal layer 131c that are described below may be collectively referred to as metal layers, and the first polymer material layer 132b, and a second polymer material layer 131b described below may be collectively referred to as polymer material layers. A surface roughness of a surface that is of a metal layer and that is connected to a polymer material layer is set to be within the foregoing range, so that the surface that is of the metal layer and that is bonded with the polymer material layer can be smooth. This can significantly reduce a void on a micro interface between the metal layer and the polymer material layer, enhance tightness of bonding between the metal layer and the polymer material layer, resolve blistering on a surface of the vapor chamber and delamination between the metal layer and the polymer material layer that are caused by gas expansion in a void in a local high-temperature process (for example, a temperature ≥ 300°) in manufacturing of the vapor chamber 13, and improve a manufacturing yield of the vapor chamber, so that the vapor chamber has good structural reliability and working performance. This effect is further described below.

As shown in FIG. 5, in an extension direction, the second cover plate 132 may be divided into a connection region 132f and a working region 132g. The connection region 132f surrounds and is connected to an outer periphery of the working region 132g, and the working region 132g protrudes relative to the connection region 132f. The working region 132g may be of a flat plate-shaped structure. The connection region 132f is configured to connect to the first cover plate 131, and the working region 132g is configured to participate in enclosing the cavity 13c. It may be understood that the first metal layer 132a, the first polymer material layer 132b, and the second metal layer 132c may be all distributed in the connection region 132f and the working region 132g.

In Embodiment 1, a material of the first metal layer 132a is metal, including but not limited to pure copper, copper alloy, stainless steel, titanium alloy, aluminum, or magnesium.

In Embodiment 1, a material of the first polymer material layer 132b is a polymer material, including but not limited to polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyvinyl chloride (polyvinyl chloride, PVC), polyvinylidene chloride (polyvinylidene chloride, PVDC), polystyrene (polystyrene, PS), or polyamide (polyamide, PA).

For example, a glass temperature Tg of the first polymer material layer 132b ≥ 320°. The glass temperature is also referred to as a glass transition temperature, and the glass temperature is a temperature at which a high polymer changes from a highly elastic state to a glass state. The glass temperature of the first polymer material layer 132b is set to be within the foregoing large range, so that the first polymer material layer 132b can have good high-temperature resistance, and the first polymer material layer 132b can maintain stable performance in a local high-temperature process (for example, soldering the first cover plate 131 and the second cover plate 132, and producing the capillary layer 133 at a high temperature of more than 300°C) in manufacturing of the vapor chamber 13. This helps improve a manufacturing yield of the vapor chamber 13, so that the vapor chamber 13 has good structural reliability and working performance.

In Embodiment 1, a material of the second metal layer 132c is metal, including but not limited to pure copper, copper alloy, stainless steel, titanium alloy, aluminum, magnesium, or metal oxide. The metal oxide includes but is not limited to titanium dioxide or aluminum oxide. The material of the second metal layer 132c may be the same as or different from that of the first metal layer 132a.

In Embodiment 1, the second cover plate 132 may be entirely produced by using a flexible copper clad laminate (flexible copper clad laminate, FCCL) material, for example, by using an adhesive-free FCCL double-sided panel material. Both the first metal layer 132a and the second metal layer 132c are copper foils, and the first polymer material layer 132b may be a PI film.

As described above, the second cover plate 132 is made of a composite of metal and nonmetal, and the second cover plate 132 may be referred to as a metal-nonmetal composite layer.

In this embodiment, the second cover plate 132 is produced by using a composite material, so that advantages of a metal material and a polymer material can be combined, and the second cover plate 132 not only has good heat conductance and strength, but also has good flexibility and a light weight.

FIG. 7 shows a partial side sectional structure of the first cover plate 131 in FIG. 4. As shown in FIG. 7, the first cover plate 131 may include the fourth metal layer 131c, the second polymer material layer 131b, and the third metal layer 131a. The three layers are sequentially arranged in a thickness direction of the first cover plate 131, and the second polymer material layer 131b is connected to the third metal layer 131a and the fourth metal layer 131c. As shown in FIG. 7 and FIG. 4, the third metal layer 131a faces the second cover plate 132.

As shown in FIG. 7, the third metal layer 131a has a surface 131d facing the second polymer material layer 131b, and the surface 131d is connected to (or bonded with) the second polymer material layer 131b. A surface roughness Rz of the surface 131d ∈ [0.5 µm, 5 µm], for example, Rz may be 0.5 µm, 1.5 µm, 2 µm, or 5 µm. The fourth metal layer 131c has a surface 131e facing the second polymer material layer 131b, and the surface 131e is connected to (or bonded with) the second polymer material layer 131b. A surface roughness Rz of the surface 131e ∈ [0.5 µm, 5 µm], for example, Rz may be 0.5 µm, 1.5 µm, 2 µm, or 5 µm. In this embodiment, the surface roughness of at least one of the surface 131d and the surface 131e may be limited as described above.

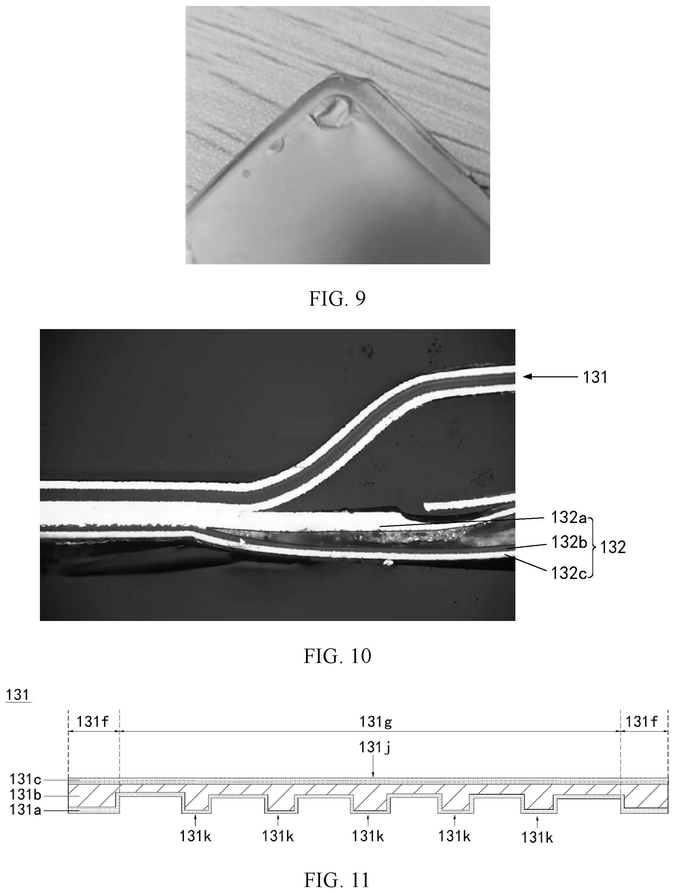

In Embodiment 1, a surface roughness of a surface that is of a metal layer and that is connected to a polymer material layer is set to be within the foregoing range, so that the surface of the metal layer can be smooth. This can significantly reduce an air gap between the metal layer and the polymer material layer after the metal layer is bonded with the polymer material layer, enhance tightness of bonding between the metal layer and the polymer material layer, and resolve blistering (as shown in FIG. 8 and FIG. 9) and delamination (as shown in FIG. 10, delamination between the first metal layer 132a and the first polymer material layer 132b) between the metal layer and the polymer material layer in a local high-temperature process (for example, a process temperature ≥ 300°) in manufacturing of the vapor chamber 13. This effect is further described below.

In an implementation of this embodiment, as shown in FIG. 7, in an extension direction, the first cover plate 131 may be divided into a connection region 131f and a working region 131g. The connection region 131f surrounds and is connected to an outer periphery of the working region 131g, and the working region 131g protrudes relative to the connection region 131f. It may be understood that the third metal layer 131a, the second polymer material layer 131b, and the fourth metal layer 131c may be all distributed in the connection region 131f and the working region 131g. The connection region 131f is configured to connect to the first cover plate 131, and the working region 131g is configured to participate in enclosing the cavity 13c.

As shown in FIG. 7, both sides of the working region 131g in a thickness direction may have uneven structures. The working region 131g may include a plurality of protrusion parts 131h and a plurality of recess parts 131i. The protrusion part 131h protrudes relative to the connection region 131f. With reference to FIG. 7 and FIG. 4, the protrusion part 131h protrudes in a direction away from the second cover plate 132, and the protrusion part 131h is spaced opposite to the second cover plate 132. The recess part 131i recesses relative to the connection region 131f. With reference to FIG. 7 and FIG. 4, the recess part 131i recesses toward the second cover plate 132, and is connected to the capillary layer 133. The recess part 131i serves as a support pillar in the vapor chamber 13, and is configured to ensure rigidity and strength of the vapor chamber 13 and improve mechanical performance of the vapor chamber 13.

As shown in FIG. 7, the protrusion part 131h and the recess part 131i in the working region 131g may be staggered, that is, arranged in a manner of a protrusion part 131h-a recess part 131i-a protrusion part 131h-a recess part 131i-a protrusion part 131h... It may be understood that FIG. 7 is at a side view angle. At a top view angle, a plurality of protrusion parts 131h may be distributed around each recess part 131i. Except for the protrusion parts 131h connected to the connection region 131f (for example, two protrusion parts 131h on leftmost and rightmost sides in FIG. 7), a plurality of recess parts 131i may be distributed around each protrusion part 131h in another position. An arrangement structure of the recess parts 131i and the protrusion parts 131h can form support pillars at a plurality of positions of the vapor chamber 13, so that the vapor chamber 13 has sufficient rigidity and strength, and the vapor chamber 13 has good mechanical performance.

Thicknesses of the first cover plate 131 in positions in FIG. 7 are basically consistent. The following describes a first cover plate 131 that is different from that shown in FIG. 7, where thicknesses of the first cover plate 131 at positions are inconsistent.

In another implementation of this embodiment, as shown in FIG. 11, one side (for example, a lower side) of the working region 131g has an uneven structure, and the other side (for example, an upper side) of the working region 131g is a flat surface. The working region 131g may include a base layer 131j, and the base layer 131j is of a flat structure. A plurality of protrusion parts 131k are protruded on a same side (for example, a lower side) of the base layer 131j, and the protrusion parts 131k are spaced from each other. With reference to FIG. 11 and FIG. 4, the protrusion part 131k faces the second cover plate 132 and is connected to the capillary layer 133. The protrusion part 131k serves as a support pillar in the vapor chamber 13, and is configured to ensure rigidity and strength of the vapor chamber 13 and improve mechanical performance of the vapor chamber 13.

In Embodiment 1, a material of the first cover plate 131 may be the same as that of the second cover plate 132.

For example, a material of the third metal layer 131a is metal, including but not limited to pure copper, copper alloy, stainless steel, titanium alloy, aluminum, or magnesium.

For example, a material of the second polymer material layer 131b is a polymer material, including but not limited to polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyvinyl chloride (polyvinyl chloride, PVC), polyvinylidene chloride (polyvinylidene chloride, PVDC), polystyrene (polystyrene, PS), or polyamide (polyamide, PA).

For example, a glass temperature Tg of the second polymer material layer 131b ≥ 320°. The glass temperature of the second polymer material layer 131b is set to be within the foregoing large range, so that the second polymer material layer 131b can have good high-temperature resistance, and the second polymer material layer 131b can maintain stable performance in a local high-temperature process (for example, soldering the first cover plate 131 and the second cover plate 132, and producing the capillary layer 133 at a high temperature of more than 300°C) in manufacturing of the vapor chamber 13. This helps improve a manufacturing yield of the vapor chamber 13, so that the vapor chamber 13 has good structural reliability and working performance.

For example, a material of the fourth metal layer 131c is metal, including but not limited to pure copper, copper alloy, stainless steel, titanium alloy, aluminum, magnesium, or metal oxide. The metal oxide includes but is not limited to titanium dioxide or aluminum oxide. The material of the fourth metal layer 131c may be the same as or different from that of the third metal layer 131a.

For example, the first cover plate 131 may be entirely produced by using an FCCL material, for example, by using an adhesive-free FCCL double-sided panel material. Both the third metal layer 131a and the fourth metal layer 131c are copper foils, and the second polymer material layer 131b may be a PI film.

As described above, the first cover plate 131 is made of a composite of metal and nonmetal, and the first cover plate 131 may be referred to as a metal-nonmetal composite layer.

In this embodiment, the first cover plate 131 is produced by using a composite material, so that advantages of a metal material and a polymer material can be combined, and the first cover plate 131 not only has good heat conductance and strength, but also has good flexibility and a light weight.

With reference to FIG. 7 (or FIG. 11), FIG. 5, and FIG. 4, the connection region 131f of the first cover plate 131 is connected to the connection region 132f of the second cover plate 132, for example, connected through soldering. The connection region 131f and the connection region 132f form the connection region 13a of the vapor chamber 13. The working region 131g of the first cover plate 131 is spaced opposite to the working region 132g of the second cover plate 132, and a region between the working region 131g and the working region 132g is the cavity 13c. The working region 131g and the working region 132g form the working region 13b of the vapor chamber 13.

As described above, the connection region 131f of the first cover plate 131 and the connection region 132f of the second cover plate 132 may be soldered together. A local high temperature is generated during soldering, for example, the temperature may reach 300°. As described above, in this embodiment, a surface roughness of a surface that is of a metal layer and that is connected to a polymer material layer is set to be within a small range, so that the surface that is of the metal layer and that is bonded with the polymer material layer can be smooth. This significantly reduces a void on a micro interface between the metal layer and the polymer material layer, enhances tightness of bonding between the metal layer and the polymer material layer, improves blistering on a surface of the vapor chamber and delamination between the metal layer and the polymer material layer that are caused by gas expansion in a void during soldering, and improves a manufacturing yield of the vapor chamber 13, so that the vapor chamber 13 has good structural reliability and working performance.

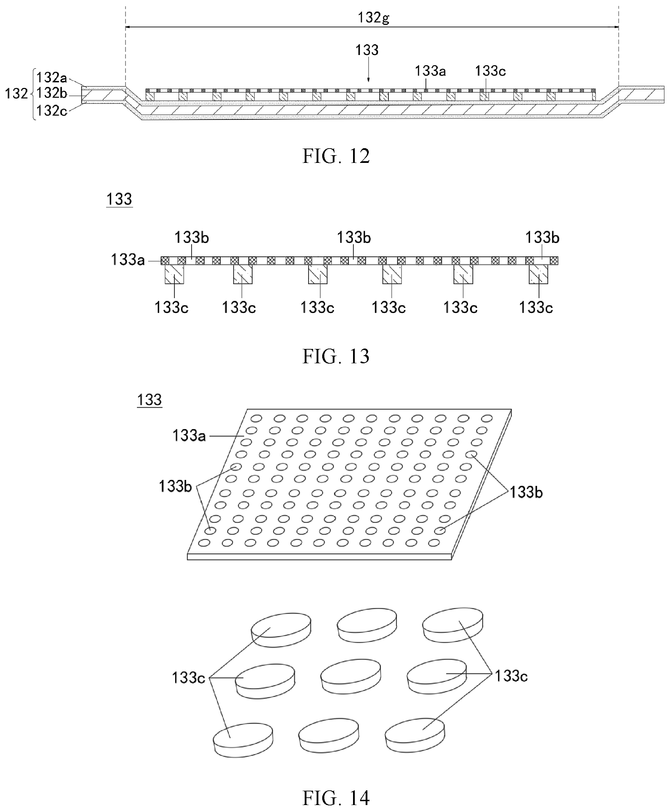

In an implementation of this embodiment, the capillary layer 133 may be produced in advance and assembled into the cavity 13c. As shown in FIG. 12, the capillary layer 133 may be connected to the first metal layer 132a, for example, may be soldered to the first metal layer 132a, and is integrated with the first metal layer 132a. Being integrated means that the capillary layer 133 and the first metal layer 132a are not assembled via a mechanical component (for example, a connector like a screw, a rivet, or a buckle, or a connection medium like an adhesive). There is no obvious interface gap at a joint between the capillary layer 133 and the first metal layer 132a, and both present a continuous or fused state. The foregoing explanation of being integrated is applicable to the following.

Alternatively, in another implementation of this embodiment, the capillary layer 133 may be formed together with the second cover plate in manufacturing of the second cover plate 132. The capillary layer 133 is a part of the second cover plate 132, and the capillary layer 133 is integrated with the first metal layer 132a. For example, the capillary layer 133 may be formed on the first metal layer 132a by using a surface processing and forming process. The surface processing and forming process includes but is not limited to etching, laser engraving, electroplating, or 3D printing.

In this embodiment, the capillary layer 133 is integrated with the first metal layer 132a, so that the capillary layer 133 and the first metal layer 132a can be fully bonded, and an air gap between the capillary layer 133 and the first metal layer 132a can be reduced. This helps improve uniform temperature heat dissipation performance of the vapor chamber 13. In addition, a mechanical component can be avoided to connect the capillary layer 133 and the first metal layer 132a, to implement lightness and thinness of the vapor chamber 13.

As described above, the integrated capillary layer 133 may be produced by using several processes, for example, soldering and laser engraving. These processes may generate a local high temperature, for example, a temperature may reach 300°. In this embodiment, a surface roughness of a surface that is of a metal layer and that is connected to a polymer material layer is set to be within a small range, so that the surface that is of the metal layer and that is bonded with the polymer material layer can be smooth. This significantly reduces a void on a micro interface between the metal layer and the polymer material layer, enhances tightness of bonding between the metal layer and the polymer material layer, improves blistering on a surface of the vapor chamber and delamination between the metal layer and the polymer material layer that are caused by gas expansion in a void in manufacturing of the capillary layer 133, and improves a manufacturing yield of the vapor chamber 13, so that the vapor chamber 13 has good structural reliability and working performance.

In another embodiment, a manner of connecting the capillary layer 133 to the first metal layer 132a may not be limited, provided that the capillary layer 133 is fastened in the cavity 13c. The following continues descriptions by using an example in which the capillary layer 133 is integrated with the first metal layer 132a.

FIG. 13 shows a side sectional structure of the capillary layer 133 in an implementation of this embodiment.

As shown in FIG. 13, the capillary layer 133 may include a capillary through-hole layer 133a and a plurality of support bodies 133c.

The capillary through-hole layer 133a may be approximately of a flat layered structure, and a thickness of the capillary through-hole layer 133a is, for example, less than or equal to 30 µm. A plurality of capillary through-holes 133b are disposed on the capillary through-hole layer 133a. The capillary through-hole 133b is configured to provide a capillary force. For example, an opening area of the capillary through-hole 133b ≤ 2000 µm², and a center distance between adjacent capillary through-holes 133b ≤ 500 µm.

All the support bodies 133c are connected to one side of the capillary through-hole layer 133a, and the support bodies 133c are spaced from each other. As shown in FIG. 13 and FIG. 12, the capillary through-hole layer 133a and the first metal layer 132a are stacked and spaced from each other, the support body 133c is connected between the capillary through-hole layer 133a and the first metal layer 132a, the support body 133c supports the capillary through-hole layer 133a, and a gap between the support bodies 133c may further serve as a channel (which will be further described below).

As shown in FIG. 13, compared with a diameter of the capillary through-hole 133b, a width of the support body 133c is larger, and a gap between two adjacent support bodies 133c is also larger. The capillary through-holes 133b on the capillary layer 133 has at least one first capillary through-hole, and at least a part of a projection of the first capillary through-hole in a thickness direction of the capillary through-hole layer 133a falls into the gap, that is, the first capillary through-hole is in communication with the gap.

FIG. 14 shows a three-dimensional disassembled structure of the capillary layer 133 in an implementation. As shown in FIG. 14, the capillary through-hole 133b may be or may be approximately a round hole, and the support body 133c may be or may be approximately a cylinder. It may be understood that FIG. 14 is merely an example, and is not intended to limit structures, sizes, quantities, relative positions, and the like of the capillary through-holes 133b and the support bodies 133c in this embodiment.

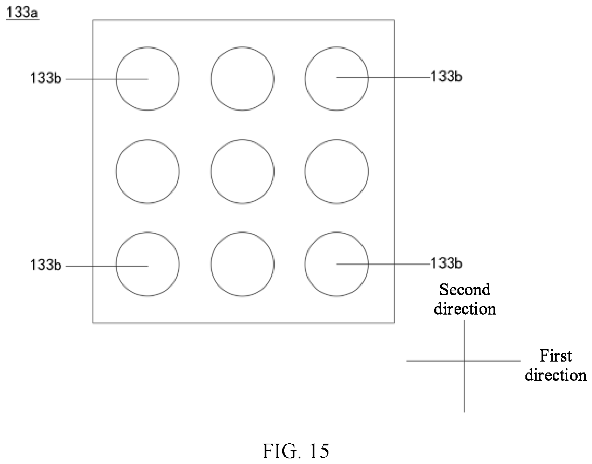

FIG. 15 to FIG. 18 show arrangement patterns of the capillary through-holes 133b in several implementations.

As shown in FIG. 15, in an implementation, the capillary through-holes 133b on the capillary through-hole layer 133a may be arranged in a matrix or a checkerboard. The capillary through-holes 133b may be arranged in a plurality of columns in a first direction and in a plurality of rows in a second direction. Centers of all capillary through-holes 133b in any two rows (or any two columns) may be connected to form a rectangle. The first direction intersects the second direction. For example, the first direction is perpendicular to the second direction. In FIG. 15, the first direction is a horizontal direction, and the second direction is a vertical direction. This is merely an example. Actually, this is not limited in embodiments of this application. The arrangement pattern shown in FIG. 15 is convenient for production.

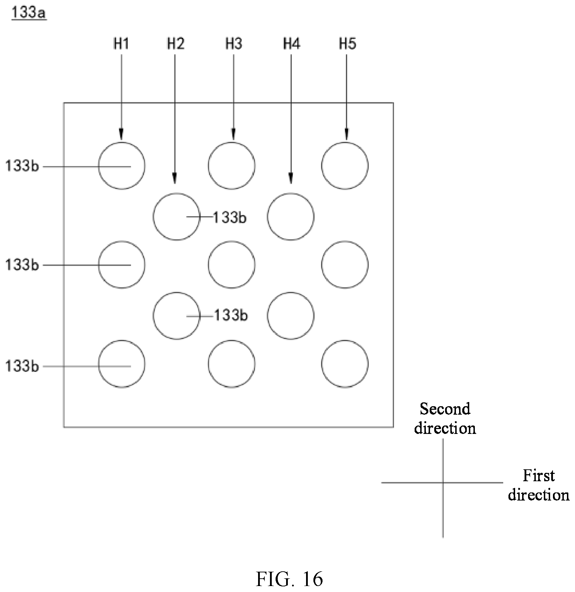

As shown in FIG. 16, in another implementation, the capillary through-holes 133b on the capillary through-hole layer 133a may include a plurality of groups sequentially arranged in the first direction, for example, a group H1, a group H2, a group H3, a group H4, and a group H5. Each group includes at least two capillary through-holes 133b sequentially arranged in the second direction. For any two adjacent groups, in the second direction, at least one capillary through-hole 133b in another group is distributed between every two adjacent capillary through-holes 133b in one group. For example, for adjacent groups H1 and H2, in the second direction, one capillary through-hole 133b in the group H2 is distributed between every two adjacent capillary through-holes 133b in the group H1, and one capillary through-hole 133b in the group H1 is distributed between every two adjacent capillary through-holes 133b in the group H2. This arrangement manner may be referred to as cross arrangement. It may be considered that a solution in FIG. 16 is based on a solution in FIG. 15. A diameter and/or pitch of the capillary through-hole 133b are/is adjusted, and one group is added between two adjacent groups, so that density and a quantity of the capillary through-holes are changed. This enables more parts of the capillary through-hole layer 133a to provide capillary forces, so that a liquid working fluid can be continuously affected by the capillary forces in a flowing process. It may be understood that a quantity and relative positions of the capillary through-holes 133b shown in FIG. 16 are merely an example, and are not limited in embodiments of this application.

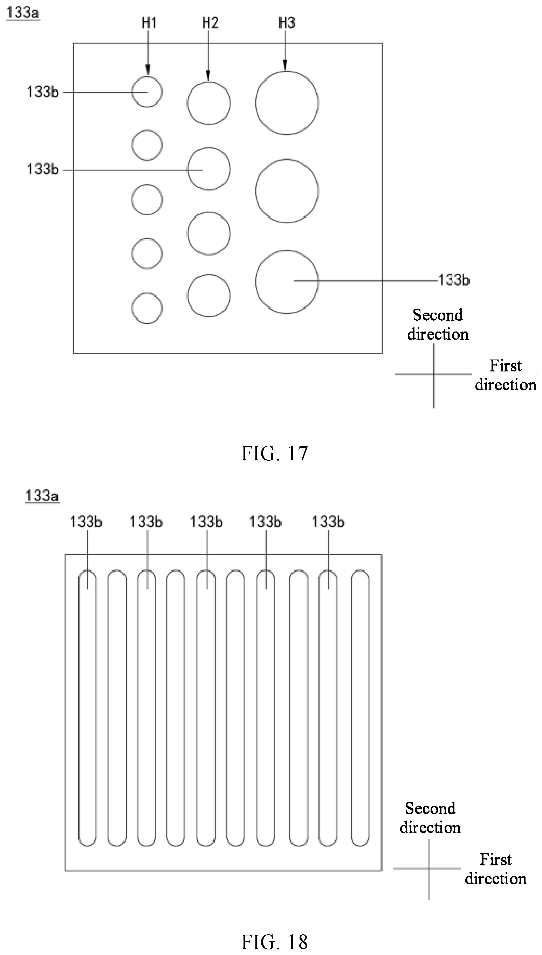

As shown in FIG. 17, in another implementation, opening areas of at least two capillary through-holes 133b in all the capillary through-holes 133b on the capillary through-hole layer 133a are different. For example, opening areas of three capillary through-holes 133b shown in FIG. 17 are different. For round holes, different opening areas also indicate different diameters. Positions of the capillary through-holes 133b whose opening areas are different from each other may be determined as required, and are not limited to those shown in FIG. 17.

For example, in a direction, for example, the first direction shown in FIG. 17, opening areas of the capillary through-holes 133b on the capillary through-hole layer 133a may be in an increasing trend. For example, opening areas of capillary through-holes 133b sequentially increase from a group H1 to a group H3. "Being in the increasing trend" includes gradually increasing, and also includes that the opening areas are in the increasing trend as a whole but may be repeated locally. For example, positions with smaller opening areas may be closer to the heat source, and capillary forces of capillary through-holes 133b in these positions are larger, so that quick fluid replenishment and return of a working fluid can be implemented. Positions with larger opening areas may be farther away from the heat source, and flow resistance in these positions is smaller, so that a condensed working fluid can easily flow through the capillary through-holes 133b and return to the channels between the support bodies 133c. It may be understood that even the capillary through-hole 133b with the larger opening area can provide a capillary force that meets a requirement.

As shown in FIG. 18, in another implementation, the capillary through-hole 133b may be an elongated and narrow slit, and an opening area of the capillary through-hole 133b is sufficient to provide a capillary force. For example, a plurality of such capillary through-holes 133b may be regularly arranged, for example, sequentially arranged in the first direction. It may be understood that the capillary through-holes 133b may also be randomly arranged as required, and are not limited to those shown in FIG. 18. All the capillary through-holes 133b on the capillary through-hole layer 133a may be slits, or only a part of capillary through-holes 133b are slits.

FIG. 14 to FIG. 18 merely enumerate some possible structures and arrangement patterns of the capillary through-holes 133b, and do not enumerate all structures and arrangement patterns of the capillary through-holes 133b. The capillary layer 133 may have the capillary through-holes 133b of one or more structures, or may have the capillary through-holes 133b in one or more arrangement patterns based on an actual requirement. In addition, the capillary through-holes 133b of each structure may be matched with one or more arrangement patterns.

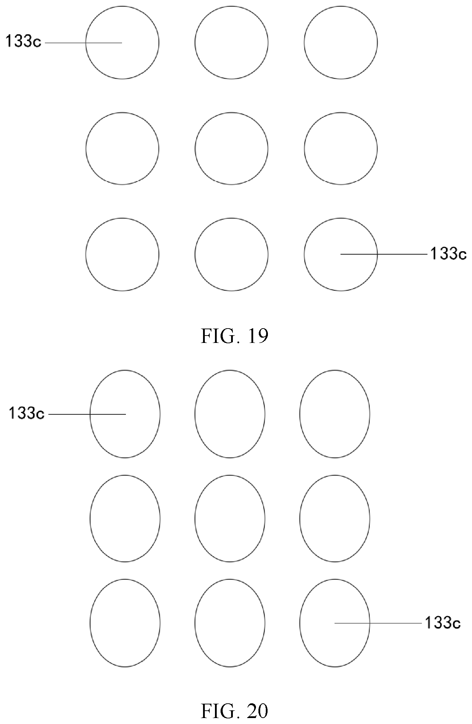

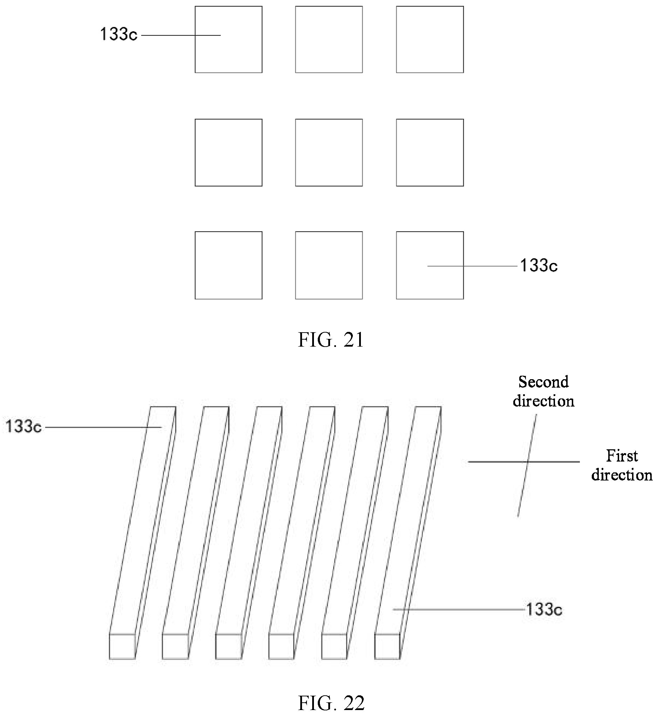

FIG. 19 to FIG. 21 show top-view structures and arrangement patterns of the support bodies 133c in different implementations. As shown in FIG. 19, a cross section of the support body 133c may be or may be approximately a circle, and the support body 133c may be or may be approximately a cylinder. As shown in FIG. 20, a cross section of the support body 133c may be or may be approximately an ellipse, and the support body 133c may be or may be approximately an elliptic cylinder. As shown in FIG. 21, a cross section of the support body 133c may be or may be approximately a rectangle, and the support body 133c may be a square pillar. In another embodiment, the support body 133c may be a prism of another shape, and a cross section of the support body 133c may be any other polygon, for example, a pentagon or a hexagon.

As shown in FIG. 19 to FIG. 21, the plurality of support bodies 133c may be dotted, and gaps in all directions may be formed between the support bodies 133c, that is, channels in all directions may be formed, and the channels are in communication with each other to form a channel network. When the vapor chamber 13 works, after a working fluid in a position in the channel network evaporates, liquid working fluids in a plurality of surrounding positions may replenish the working fluid in the position. In this way, the vapor chamber 13 is insensitive to a position of the heat source, and the vapor chamber 13 can correspond to a plurality of heat sources to conduct heat and dissipate heat for the plurality of heat sources. Alternatively, a position of the vapor chamber 13 can be fastened, and a position of the heat source can be adjusted as required, so that the vapor chamber 13 can always properly conduct heat and dissipate heat. In addition, this can alleviate a defect that a temperature in the position increases excessively because the working fluid is evaporated at the position and the liquid working fluid cannot be replenished, and reduce a phenomenon that a flow of the working fluid is unstable during boiling and evaporation. The foregoing principle is further described below.

FIG. 22 shows three-dimensional structures and an arrangement pattern of the support bodies 133c in another implementation. As shown in FIG. 22, the plurality of support bodies 133c may be sequentially arranged in a first direction, and each support body 133c may be of a strip-shaped structure extending in a second direction. The second direction is a length direction of the support body 133c, and a size of each support body 133c in the second direction is greater than a size of the support body 133c in another direction. In this way, a channel extending in the second direction may be formed between any two adjacent support bodies 133c, and the channel may be referred to as a groove. Widths of the grooves in positions may be consistent or basically consistent, and the grooves may be parallel. The groove is for flow of a liquid working fluid. Refer to FIG. 22, the widths of the grooves are basically constant. Therefore, the liquid working fluid in the groove has strong flow directivity and small flow resistance, so that the liquid working fluid can quickly replenish a liquid working fluid in an evaporation position, thereby ensuring heat conduction and heat dissipation effect. The foregoing principle is further described below.

In this embodiment, all the support bodies 133c in the capillary layer 133 may use the structure and arrangement pattern shown in FIG. 22, and this support body 133c may be referred to as a first support body. Alternatively, only a part of support bodies 133c use the structure and arrangement pattern shown in FIG. 22, and the support body 133c may be referred to as a first support body. The other support bodies 133c may use another structure and arrangement pattern, for example, one or more structures and arrangement patterns in FIG. 19 to FIG. 21.

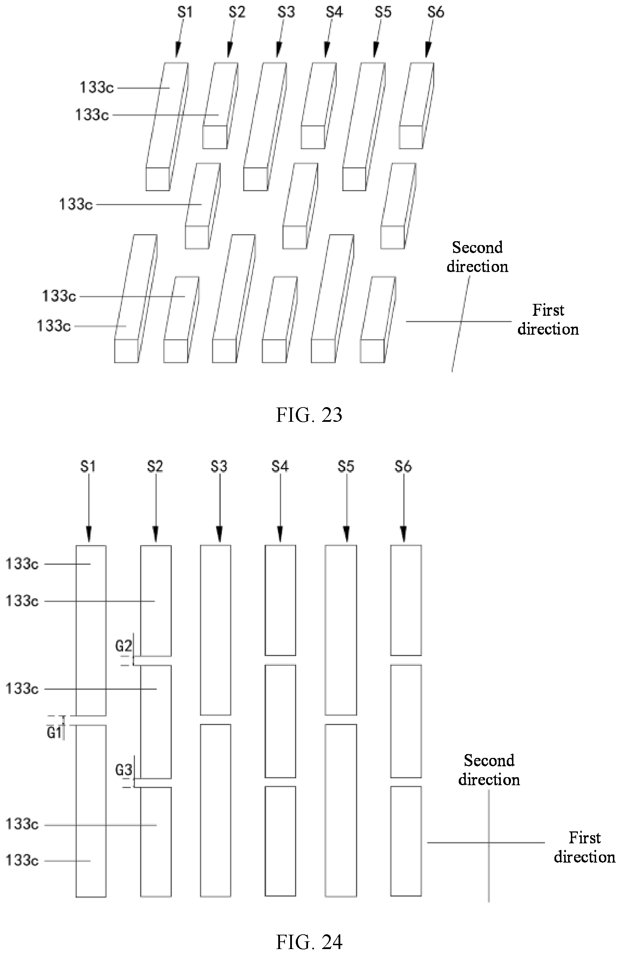

Based on the implementation shown in FIG. 22, FIG. 23 shows three-dimensional structures and an arrangement pattern of the support bodies 133c in another implementation, and FIG. 24 is a top view of FIG. 23.

As shown in FIG. 23 and FIG. 24, the plurality of support bodies 133c may be arranged into a plurality of groups in the first direction, for example, a group S1, a group S2, a group S3, a group S4, a group S5, and a group S6. Each group may include at least two support bodies 133c sequentially arranged in the second direction. For example, there are two support bodies 133c sequentially arranged in the second direction in the group S1, and there are three support bodies 133c sequentially arranged in the second direction in the group S2. Any one of two adjacent groups may be referred to as a first group, and the other group may be referred to as a second group. For example, the group S1 may be referred to as the first group, and the group S2 may be referred to as the second group, or the group S1 may be referred to as the second group, and the group S2 may be referred to as the second group. Certainly, the group S2 and the group S3 may be referred to as the first group and the second group, respectively. It may be understood that a quantity of support bodies 133c in FIG. 23 and FIG. 24 is merely an example, and is not limited in embodiments of this application.

As shown in FIG. 24, a projection of a gap between any two adjacent support bodies 133c in the first group in the first direction falls on one support body 133c in the second group. For example, a projection of a gap G1 between two adjacent support bodies 133c in the group S1 in the first direction may fall on a middle support body 133c in the group S2; a projection of a gap G2 between two adjacent support bodies 133c in the group S2 in the first direction may fall on an upper support body 133c in the group S1; and a projection of a gap G3 between two adjacent support bodies 133c in the group S2 in the first direction may fall on a lower support body 133c in the group S1.

As shown in FIG. 24, a groove (a channel extending in the second direction) is formed between every two adjacent groups, and widths of the grooves are basically constant.

It may be understood with reference to the foregoing descriptions that the implementation shown in FIG. 24 can integrate advantages of the implementation shown in FIG. 22 and the implementation shown in FIG. 21. To be specific, because the groove is formed, the liquid working fluid in the groove has strong flow directivity and small flow resistance, so that the liquid working fluid can quickly replenish a liquid working fluid in an evaporation position, thereby ensuring heat conduction and heat dissipation effect. In addition, a gap (for example, the gap G1, the gap G2, and the gap G3) may be formed between adjacent support bodies 133c in each group, and the gap is also a channel between the adjacent support bodies 133c. The gap is in communication with the groove, to form a channel network that communicates in upward, downward, leftward, and rightward directions. When the vapor chamber 13 works, after a working fluid in a position in the channel network evaporates, liquid working fluids in a plurality of surrounding positions may replenish the working fluid in the position. Therefore, the vapor chamber 13 is insensitive to a position of the heat source, and the vapor chamber 13 can correspond to a plurality of heat sources to conduct heat and dissipate heat for the plurality of heat sources. Alternatively, a position of the vapor chamber 13 can be fastened, and a position of the heat source can be adjusted as required, so that the vapor chamber 13 can always properly conduct heat and dissipate heat. In addition, this can alleviate a defect that a temperature in the position increases excessively because the working fluid is vaporized and evaporated at the position and then the liquid working fluid cannot be replenished, and reduce a phenomenon that a flow of the working fluid is unstable during boiling and evaporation. In addition, the gap (for example, the gap G1, the gap G2, and the gap G3) between the adjacent support bodies 133c in each group is small, and the gap may be less than the width of the groove between the adjacent support bodies 133c. The gap may provide a specific capillary force. This helps improve fluidity of a liquid working fluid, ensure quick replenishment of the liquid working fluid, and improve heat conduction and heat dissipation effect. The foregoing principle is further described below.

In this embodiment, all the support bodies 133c in the capillary layer 133 may use a solution shown in FIG. 22; or all the support bodies 133c may use a solution shown in FIG. 24; or a part of support bodies 133c may use a solution shown in FIG. 22, and the other support bodies 133c may use a solution shown in FIG. 24; or a part of support bodies 133c may use a solution shown in FIG. 22 and/or FIG. 24, and the other support bodies 133c may use one or more solutions shown in FIG. 19 to FIG. 21. In this embodiment, all support bodies 133c that use the solution shown in FIG. 22 or FIG. 24 may be referred to as the first support bodies.

FIG. 19 to FIG. 24 merely enumerate some possible structures and arrangement patterns of the support bodies 133c, and do not enumerate all structures and arrangement patterns of the support bodies 133c. The capillary layer 133 may have the support bodies 133c of one or more structures, or may have the support bodies 133c in one or more arrangement patterns based on an actual requirement. In addition, the support bodies 133c of each structure may be matched with one or more arrangement patterns.

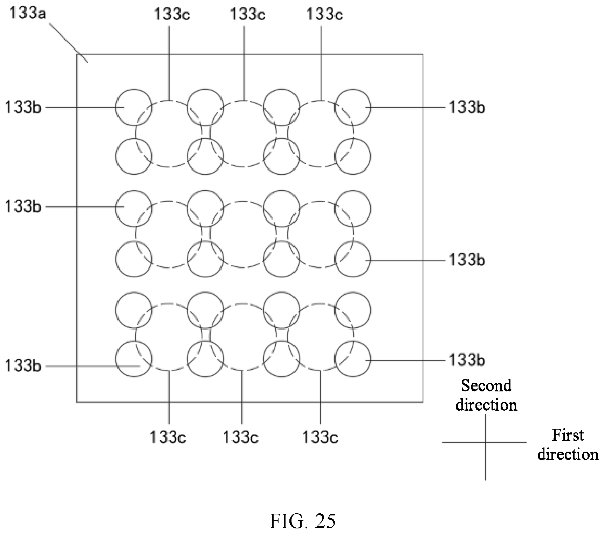

FIG. 25 to FIG. 28 show position relationships between capillary through-holes 133b and support bodies 133c in several implementations at a top-view angle, where the support bodies 133c below the capillary through-hole layer 133a are indicated by dashed lines. It may be understood that structures and arrangement patterns of the capillary through-holes 133b and structures and arrangement patterns of the support bodies 133c in FIG. 25 to FIG. 28 are examples, and are not intended to limit this embodiment.

As shown in FIG. 25, in an implementation, the support body 133c may overlap with at least one capillary through-hole 133b. Overlapping means that the support body 133c may block at least a part of the capillary through-hole 133b. For example, a support body 133c may overlap with a plurality of capillary through-holes 133b. There may be a plurality of such support bodies 133c. For example, each support body 133c in the capillary layer 133 may overlap with a plurality of capillary through-holes 133b.

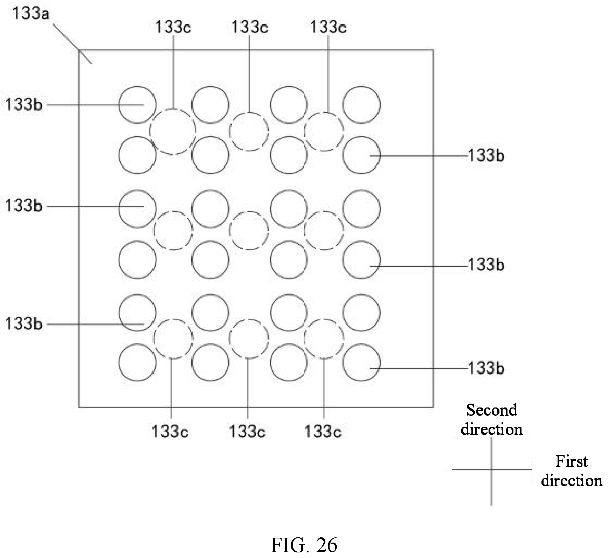

Different from that shown in FIG. 25, as shown in FIG. 26, in another implementation, at least one support body 133c does not overlap with the capillary through-hole 133b. In other words, the support body 133c completely avoids the capillary through-hole 133b, and the support body 133c may be disposed in an unperforated region in the capillary through-hole layer 133a. For example, each support body 133c in the capillary layer 133 does not overlap with the capillary through-hole 133b. In other words, each support body 133c may be disposed in the unperforated region.

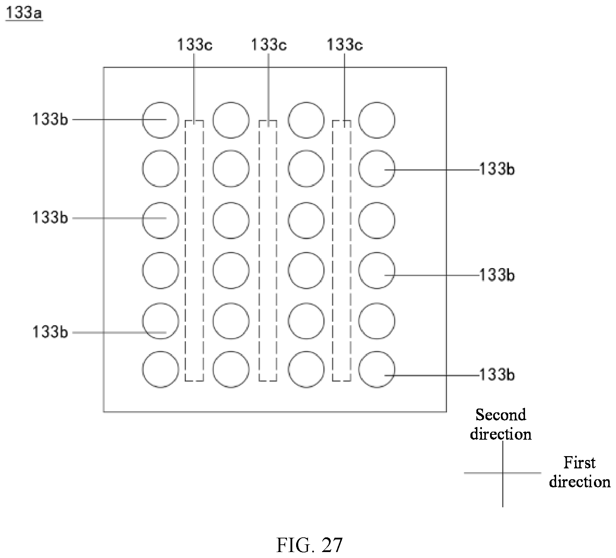

Different from that shown in FIG. 26, as shown in FIG. 27, the circular capillary through-hole 133b may be matched with the support body 133c of the strip-shaped structure.

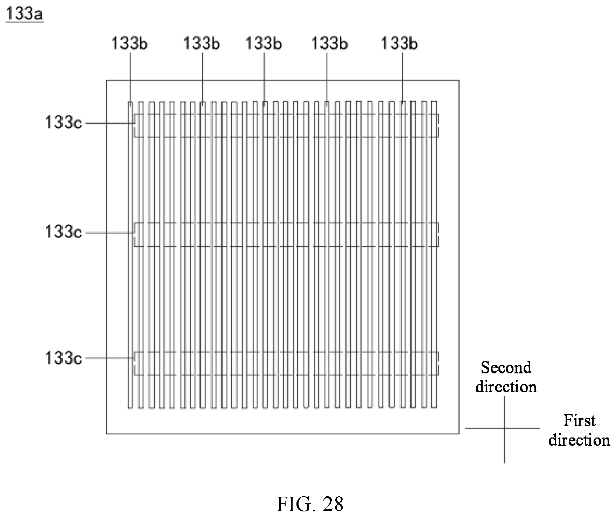

As shown in FIG. 28, in another implementation, the capillary through-hole 133b may be a slit, the support body 133c may be of a strip-shaped structure, and an extension direction of the slit may intersect with an extension direction of the strip-shaped structure. In this way, the support body 133c may overlap a plurality of capillary through-holes 133b, and a groove between two adjacent support bodies 133c may be in communication with the plurality of slits. It may be understood that a width of a groove between two adjacent support bodies 133c may be large to accommodate more liquid working fluids, so that the plurality of slits in communication with the groove can fully absorb the liquid working fluids, thereby finally ensuring heat conduction efficiency.

It may be understood based on FIG. 25 to FIG. 28 that in this embodiment, a design (including at least one of a structure and an arrangement pattern) of the capillary through-hole 133b may be used in combination with a design (including at least one of a structure and an arrangement pattern) of the support body 133c, and each design of the capillary through-hole 133b may be matched with one or more designs of the support body 133c.

In the foregoing implementation, as shown in FIG. 12, the working region 132g of the second cover plate 132 is basically of a flat layer structure, and the support body 133c is directly protruded on the first metal layer 132a. Based on the foregoing implementation, a structure of the working region 132g may be adjusted, so that the working region 132g has a plurality of protrusion parts, and then the support bodies 133c covering the protrusion parts are formed. A description is given below.

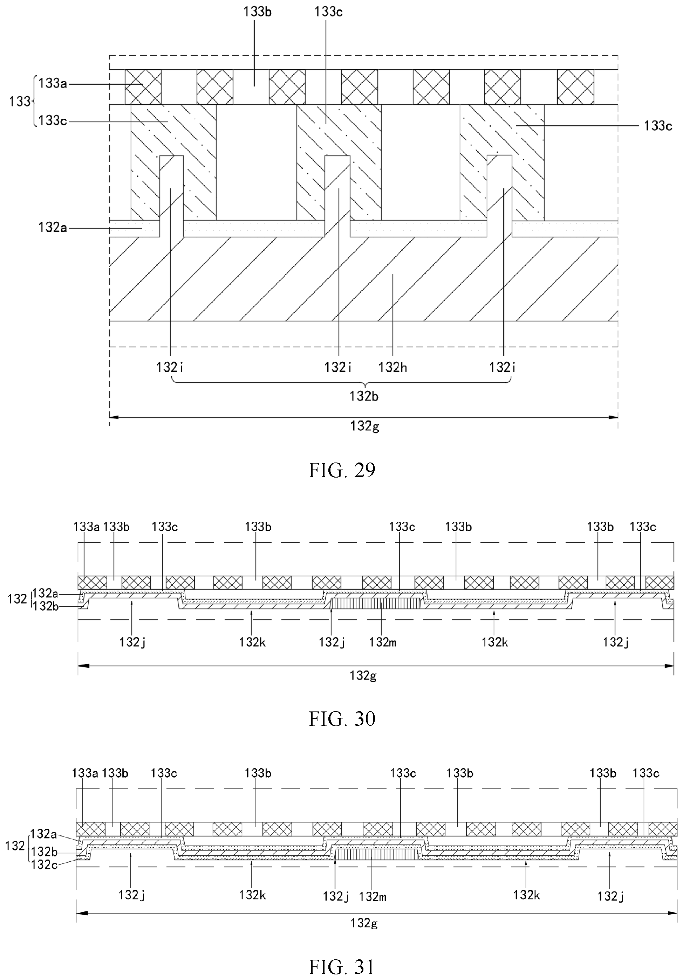

FIG. 29 shows a partial side sectional structure of the capillary layer 133 and the second cover plate 132 in another implementation, and does not show the second metal layer 132c. As shown in FIG. 29, the first polymer material layer 132b may include the base layer 132h and the plurality of protrusion parts 132i. The base layer 132h may be of a flat layer structure, and the protrusion parts 132i are protruded on a same side (for example, an upper side) of the base layer 132h. With reference to FIG. 29 and FIG. 4, the protrusion parts 132i are protruded on a side that is of the base layer 132h and that faces the first cover plate 131. The first metal layer 132a covers the base layer 132h. Each support body 133c wraps one protrusion part 132i, and connects the first metal layer 132a and the capillary through-hole layer 133a. It may be considered that each support body 133c and the protrusion part 132i wrapped by the support body 133c jointly form a support pillar structure.

For example, the first metal layer 132a and the support body 133c may be made of a same material, for example, pure copper or copper alloy.

For example, the first polymer material layer 132b having the protrusion part 132i may be produced by using a process like etching (for example, PI etching), laser engraving, or hot pressing, and then a copper layer is formed on the first polymer material layer 132b by using an electroplating process. In the copper layer, a part that covers the base layer 132h may be referred to as the first metal layer 132a, and a part that covers the protrusion part 132i may be referred to as the support body 133c. It may be understood that FIG. 29 shows a boundary between the first metal layer 132a and the support body 133c, and the boundary is merely an example for clear display.

Compared with that in the implementation shown in FIG. 12, in the implementation shown in FIG. 29, the support body 133c and the protrusion part 132i wrapped by the support body 133c jointly form one support pillar structure, and the protrusion part 132i is produced by using a light polymer material. Therefore, the support pillar structure is light, and helps reduce a weight of the vapor chamber 13. In addition, this structure has high processing precision, and can ensure structural precision of the vapor chamber 13.

FIG. 30 shows a partial side sectional structure of the working region 132g and the capillary layer 133 in another implementation, and does not show the second metal layer 132c. As shown in FIG. 30, thicknesses of the second cover plate 132 in positions may be basically consistent, and a plurality of recess parts 132j may be disposed on a side that is of the working region 132g and that is away from the first cover plate 131. The recess part 132j is formed by jointly recessing the first metal layer 132a and the first polymer material layer 132b. The recess part 132j may be in a pit or groove shape, and a dimension of the recess part 132j may be, for example, between 100 µm and 200 µm, and a depth of the recess part 132j may be, for example, about 20 µm. With reference to FIG. 30 and FIG. 4, each recess part 132j recesses toward the first cover plate 131, or recesses toward the cavity 13c of the vapor chamber 13. Therefore, each recess part 132j forms a protrusion on an inner wall of the cavity 13c, and a recess is formed between adjacent protrusions. A part that is of the first metal layer 132a and that is located in each recess part 132j serves as a support body 133c, and each support body 133c is connected to the capillary through-hole layer 133a. A channel is formed between any two adjacent support bodies 133c, and a shape of the channel may be determined as required. For example, the channel may be a strip-shaped groove or a pit-shaped groove. The channel is in communication with the capillary through-hole 133b. In this implementation, it may be considered that the capillary layer 133 is the capillary through-hole layer 133a, or the capillary layer 133 includes the capillary through-hole layer 133a and the part that is of the first metal layer 132a and that is located in each recess part 132j.

Compared with that in the implementation shown in FIG. 12, in the implementation shown in FIG. 30, the first metal layer 132a may be used to form the support body 133c. Therefore, a thickness and a weight of the second cover plate 132 can be reduced. In addition, the second cover plate 132 in FIG. 30 has high processing precision, and can ensure structural precision of the vapor chamber 13.

Based on FIG. 30, in another implementation, as shown in FIG. 31, the second cover plate 132 may also include the second metal layer 132c, and the recess part 132j is formed by jointly recessing the first metal layer 132a, the first polymer material layer 132b, and the second metal layer 132c. In the implementation shown in FIG. 31, the second metal layer 132c is added, so that the second cover plate 132 has good structural strength and rigidity and good mechanical performance.

As shown in FIG. 30 and FIG. 31, for example, each recess part 132j may be filled with a thermally conductive material 132m. In FIG. 30 and FIG. 31, to clearly mark the recess part 132j and the thermally conductive material 132m, the thermally conductive material 132m is filled in only one recess part 132j. This is merely an example. The thermally conductive material 132m may completely fill the recess part 132j, so that the second cover plate 132 has a flat outer surface. The thermally conductive material 132m has good thermally conductive performance, and includes but is not limited to a thermally conductive adhesive including a graphene component, or a phase change material (phase change material, PCM). The thermally conductive material 132m is used to discharge air (the air is a poor heat conductor) in the recess part 132j, to enhance heat conduction between the second cover plate 132 and the heat source. It may be understood that, in another implementation, the thermally conductive material 132m may not be disposed.

The following describes a working principle of the vapor chamber 13.

Refer to FIG. 4. The first cover plate 131 may be away from the heat source, and the second cover plate 132 may face the heat source. Heat of the heat source is absorbed by the second cover plate 132. In the vapor chamber 13, a region close to the heat source is a high-temperature region, and a region far away from the heat source is a low-temperature region. A liquid working fluid in the high-temperature region absorbs heat and evaporates, flows from the high-temperature region to the low-temperature region, and condenses in the low-temperature region. The liquid working fluid also fills in the channel between adjacent support bodies 133c and the capillary through-hole 133b. At a position of the capillary layer 133, evaporation of the liquid working fluid in the channel and the capillary through-hole 133b at the position causes a liquid level at the position to decrease. The capillary through-hole 133b can provide the capillary force, so that a liquid working fluid from another surrounding position can be absorbed in the position to replenish the liquid level. This can implement circulation of the working fluid. In a flow process of the working fluid, the working fluid transmits heat from the high-temperature region to the low-temperature region, to implement heat conduction and heat dissipation effect.

Based on the foregoing working principle, working mechanisms and technical effect of the capillary through-hole 133b and the support body 133c may be understood.

For the capillary through-holes 133b shown in FIG. 16, cross arrangement is used for the capillary through-holes 133b shown in FIG. 16 to increase density and a quantity of the capillary through-holes 133b, so that more parts of the capillary layer 133 can provide capillary forces, and the liquid working fluid can continuously receive the capillary force in the flow process, thereby increasing a fluid replenishment and return speed, and helping improve heat conduction and heat dissipation efficiency.

For the capillary through-holes 133b shown in FIG. 17, the opening areas of the capillary through-holes 133b may be in the increasing trend. For example, the opening areas of the capillary through-holes 133b sequentially increase from the group H1 to the group H3. For example, positions with smaller opening areas may be closer to the heat source, and capillary forces of capillary through-holes 133b in these positions are larger, so that quick fluid replenishment and return of the working fluid can be implemented, thereby facilitating quick heat conduction and heat dissipation in the high-temperature region. Positions with larger opening areas may be farther away from the heat source, and flow resistance in these positions is smaller, so that a condensed working fluid can easily flow through the capillary through-holes 133b and return to the channels between the support bodies 133c, thereby helping improve a return speed and further improving heat conduction and heat dissipation efficiency.

For the support bodies 133c shown in FIG. 19 to FIG. 21, the support bodies 133c are dotted, and the channel network is formed between the support bodies 133c. When the vapor chamber 13 works, after a working fluid in a position in the channel network evaporates, liquid working fluids in a plurality of surrounding positions may replenish the working fluid in the position. In this design, the vapor chamber 13 is insensitive to a position of the heat source, and the vapor chamber 13 can correspond to a plurality of heat sources to conduct heat and dissipate heat for the plurality of heat sources. Alternatively, a position of the vapor chamber 13 can be fastened, and a position of the heat source can be adjusted as required, so that the vapor chamber 13 can always properly conduct heat and dissipate heat. In addition, this can alleviate a defect that a temperature in the position increases excessively because the working fluid is evaporated at the position and the liquid working fluid cannot be replenished, and reduce a phenomenon that a flow of the working fluid is unstable during boiling and evaporation.

For the support bodies 133c shown in FIG. 22, the widths of the grooves between the adjacent support bodies 133c are basically constant. Therefore, the liquid working fluid in the groove has strong flow directivity and small flow resistance, so that the liquid working fluid can quickly replenish a liquid working fluid in an evaporation position, thereby ensuring heat conduction and heat dissipation effect.

For the support bodies 133c shown in FIG. 24, the advantages of the implementations in FIG. 22 and FIG. 21 may be integrated. To be specific, because the groove is formed, the liquid working fluid in the groove has strong flow directivity and small flow resistance, so that the liquid working fluid can quickly replenish a liquid working fluid in an evaporation position, thereby ensuring heat conduction and heat dissipation effect. In addition, the gap (for example, the gap G1, the gap G2, and the gap G3) may be formed between adjacent support bodies 133c in each group, and the gap is in communication with the groove, to form the channel network that communicates in upward, downward, leftward, and rightward directions. When the vapor chamber 13 works, after a working fluid in a position in the channel network evaporates, liquid working fluids in a plurality of surrounding positions may replenish the working fluid in the position. Therefore, the vapor chamber 13 is insensitive to a position of the heat source, and the vapor chamber 13 can correspond to a plurality of heat sources to conduct heat and dissipate heat for the plurality of heat sources. Alternatively, a position of the vapor chamber 13 can be fastened, and a position of the heat source can be adjusted as required, so that the vapor chamber 13 can always properly conduct heat and dissipate heat. In addition, this can alleviate a defect that a temperature in the position increases excessively because the working fluid is vaporized and evaporated at the position and then the liquid working fluid cannot be replenished, and reduce a phenomenon that a flow of the working fluid is unstable during boiling and evaporation. In addition, the gap (for example, the gap G1, the gap G2, and the gap G3) between the adjacent support bodies 133c in each group is small, and the gap may be less than the width of the groove between the adjacent support bodies 133c. The gap may provide a specific capillary force. This helps improve fluidity of a liquid working fluid, ensure quick replenishment of the liquid working fluid, and improve heat conduction and heat dissipation effect.

Based on the foregoing embodiments, material composition of the first cover plate 131 and the second cover plate 132 may be adjusted to obtain other embodiments. A description is given below.

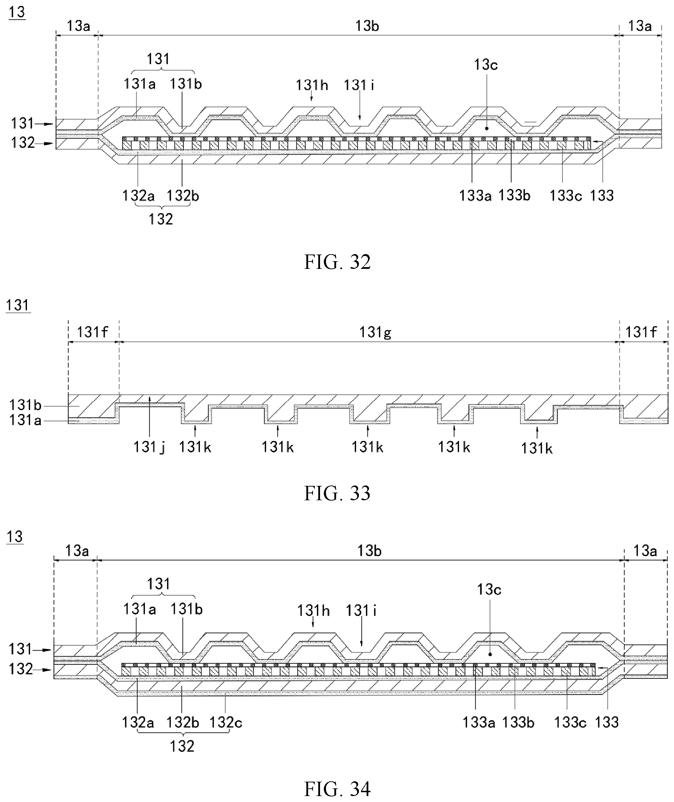

FIG. 32 shows a partial side sectional structure of the vapor chamber 13 in Embodiment 2. As shown in FIG. 32 and FIG. 4, compared with that in Embodiment 1, the vapor chamber 13 in Embodiment 2 may be as follows: The first cover plate 131 may include the third metal layer 131a and the second polymer material layer 131b, but does not include the fourth metal layer 131c. The second cover plate 132 may include the first metal layer 132a and the first polymer material layer 132b, but does not include the second metal layer 132c. The first cover plate 131 and the second cover plate 132 each may be an adhesive-free FCCL single panel. The vapor chamber 13 in Embodiment 2 has two fewer metal layers, and therefore is lighter and thinner, more flexible, more bendable, has lower process difficulty, and can meet a product requirement.

It can be understood that a structure of the capillary layer 133 in FIG. 32 is the consistent with that in FIG. 4, and this is merely an example. Actually, the capillary layer 133 in Embodiment 2 may also use the structure shown in FIG. 23.

As shown in FIG. 32, in an implementation of Embodiment 2, the first cover plate 131 may use an equal thickness design, and both sides of the first cover plate 131 in a thickness direction may have uneven structures, to form support pillars. As shown in FIG. 33, in another implementation of Embodiment 2, the first cover plate 131 may use an unequal thickness design. One side (for example, a lower side) of the working region 131g of the first cover plate 131 has an uneven structure, and the plurality of protrusion parts 131k are formed. The protrusion parts 131k serve as support pillars. The other side (for example, an upper side) of the working region 131g is a flat surface.

Based on Embodiment 2, FIG. 34 shows a partial side sectional structure of the vapor chamber 13 in Embodiment 3. Compared with Embodiment 2, as shown in FIG. 34, Embodiment 3 may be as follows: The second cover plate 132 may include the first metal layer 132a, the first polymer material layer 132b, and the second metal layer 132c, and the second cover plate 132 may be, for example, an adhesive-free FCCL double-sided panel. The first cover plate 131 in Embodiment 3 has one fewer metal layer, and therefore is lighter and thinner, more flexible, more bendable, has lower process difficulty, and can meet a product requirement. In addition, with reference to FIG. 34 and FIG. 3, in an implementation, the second polymer material layer 131b in the first cover plate 131 may be connected to the display 11. The second polymer material layer 131b is soft, and therefore has a small impact on the display 11, and further play a buffer protection role for the display 11.

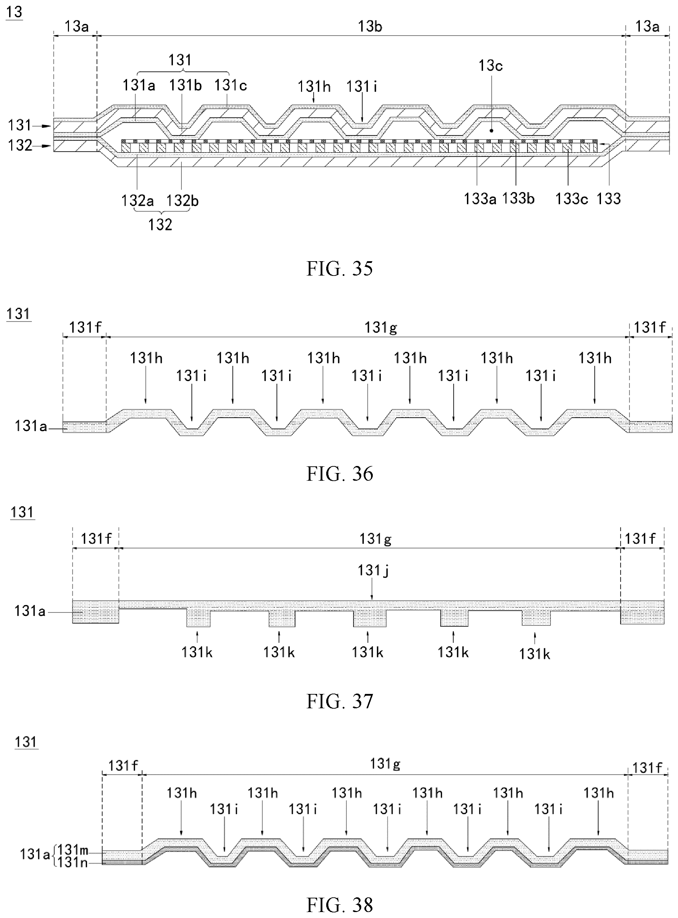

Based on Embodiment 2, FIG. 35 shows a partial side sectional structure of the vapor chamber 13 in Embodiment 4. Compared with Embodiment 2, as shown in FIG. 35, Embodiment 4 may be as follows: The first cover plate 131 may include the third metal layer 131a, the second polymer material layer 131b, and the fourth metal layer 131c, and the first cover plate 131 may be, for example, an adhesive-free FCCL double-sided panel. The second cover plate 132 in Embodiment 4 has one fewer metal layer, and therefore is lighter and thinner, more flexible, more bendable, has lower process difficulty, and can meet a product requirement. In addition, the first polymer material layer 132b in the second cover plate 132 may face a heat source device. The first polymer material layer 132b is soft, and therefore has a small impact on the heat source device, and can play a buffer protection role. Due to insulation performance of the first polymer material layer 132b, the first polymer material layer 132b does not affect working of the heat source device.

In the foregoing embodiments, the first cover plate 131 is made of a metal-nonmetal composite material. The following describes, based on the foregoing embodiment, an embodiment in which the first cover plate 131 is made of metal or a metal composite material.

FIG. 36 shows a partial side sectional structure of the first cover plate 131 in Embodiment 5. Different from that in the foregoing embodiment, as shown in FIG. 36, the first cover plate 131 in Embodiment 5 includes the third metal layer 131a, but does not include the second polymer material layer 131b or the fourth metal layer 131c. A material of the third metal layer 131a may be pure copper or copper alloy. The first cover plate 131 in Embodiment 5 is lighter and thinner, has lower costs, and can meet a product requirement.

As shown in FIG. 36, in an implementation of Embodiment 5, the first cover plate 131 may use an equal thickness design, and both sides of the first cover plate 131 in a thickness direction may have uneven structures, to form support pillars. As shown in FIG. 37, in another implementation of Embodiment 5, the first cover plate 131 may use an unequal thickness design. One side (for example, a lower side) of the working region 131g of the first cover plate 131 has an uneven structure, and the plurality of protrusion parts 131k are formed. The protrusion parts 131k serve as support pillars. The other side (for example, an upper side) of the working region 131g is a flat surface.

FIG. 38 shows a partial side sectional structure of the first cover plate 131 in Embodiment 6. Different from that in Embodiment 5, the material of the third metal layer 131a in Embodiment 6 may be the metal composite material that is composite of different pieces of metal. As shown in FIG. 38, the third metal layer 131a may include a metal layer 131m and a metal layer 131n, the metal layer 131m and the metal layer 131n are made of different metal materials, the metal layer 131m includes but is not limited to stainless steel, titanium, aluminum, or magnesium, and the metal layer 131n may be pure copper or copper alloy. The metal layer 131n faces the second cover plate 132 and is connected to the second cover plate 132. A solution in Embodiment 6 can increase strength of the first cover plate 131 and improve bending resistance of the first cover plate 131.

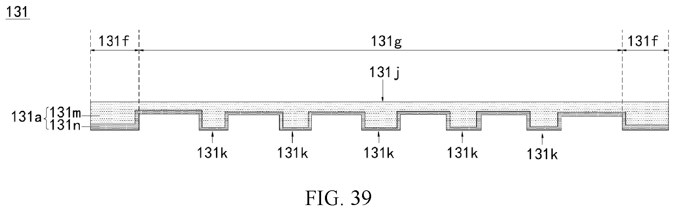

As shown in FIG. 38, in an implementation of Embodiment 6, the first cover plate 131 may use an equal thickness design, and both sides of the first cover plate 131 in a thickness direction may have uneven structures, to form support pillars. As shown in FIG. 39, in another implementation of Embodiment 6, the first cover plate 131 may use an unequal thickness design. One side (for example, a lower side) of the working region 131g of the first cover plate 131 has an uneven structure, and the plurality of protrusion parts 131k are formed. The protrusion parts 131k serve as support pillars. The other side (for example, an upper side) of the working region 131g is a flat surface.

In embodiments of this application, for differentiation, the base layer 132h may be referred to as a first base layer, the base layer 131j may be referred to as a second base layer, the protrusion part 132i may be referred to as a first protrusion part, the protrusion part 131h may be referred to as a second protrusion part, the protrusion part 131k may be referred to as a third protrusion part, the recess part 132j may be referred to as a first recess part, and the recess part 131i may be referred to as a second recess part.

Solutions in embodiments of this application can improve thermally conductive performance of the vapor chamber 13, increase a maximum heat transfer amount Qmax of the vapor chamber 13, and further reduce the weight of the vapor chamber 13 and the thickness of the vapor chamber 13. The solutions in embodiments of this application help improve a heat dissipation capability of the electronic device 1, increase maximum main frequency duration of a chip in the electronic device 1, and help implement lightness and thinness of the entire device.

For ease of understanding, the following explains and describes related technical terms used in embodiments of this application.

In descriptions of embodiments of this application, unless otherwise specified, "a plurality of" means two or more.

Terms such as "first" and "second" are used only for description purposes, and cannot be understood as an indication or implication of relative importance or an implicit indication of a quantity of indicated technical features. A feature limited by "first" or "second" may explicitly or implicitly include one or more features.

"Connection" should be understood in a broad sense. For example, "connection" may be a detachable connection, a nondetachable connection, a direct connection, or an indirect connection through an intermediate medium. "Fastening" should also be understood in a broad sense. For example, "fastening" may be direct fastening or indirect fastening through an intermediate medium.

The orientation terms mentioned in embodiments of this application, for example, "upper", "lower", "front", "rear", "left", "right", "inside", "outside", "side", "top", and "bottom" are merely directions with reference to the accompanying drawings. The orientation terms are used to better and more clearly describe and understand embodiments of this application, instead of explicitly indicating or implying that a specified apparatus or element needs to have a specific orientation and be constructed and operated in a specific orientation, and therefore cannot be understood as limitations on embodiments of this application.

In the descriptions of embodiments of this application, unless otherwise specified, "and/or" is merely an association relationship for describing an associated object, and indicates that three relationships may exist. For example, A and/or B may represent the following three cases: Only A exists alone, both A and B exist, and only B exists.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A vapor chamber (13), comprising
a first cover plate (131), a second cover plate (132), and a capillary layer (133), wherein the first cover plate (131) and the second cover plate (132) are stacked, the first cover plate (131) and the second cover plate (132) are connected and enclose a cavity (13c), and the capillary layer (133) is located in the cavity (13c); and
the second cover plate (132) comprises a first metal layer (132a) and a first polymer material layer (132b), the first metal layer (132a) and the first polymer material layer (132b) are stacked, the first metal layer (132a) is connected between the first polymer material layer (132b) and the first cover plate (131), and a surface roughness Rz of a surface (132d) that is of the first metal layer (132a) and that is connected to the first polymer material layer (132b) ∈ [0.5 µm, 5 µm].

2. The vapor chamber (13) according to claim 1, wherein
the capillary layer (133) is integrated with the first metal layer (132a).

3. The vapor chamber (13) according to claim 1 or 2, wherein
the capillary layer (133) comprises a capillary through-hole layer (133a) and a plurality of support bodies (133c), and the plurality of support bodies (133c) are connected between the capillary through-hole layer (133a) and the first metal layer (132a); and
a plurality of capillary through-holes (133b) are disposed on the capillary through-hole layer (133a), the plurality of capillary through-holes (133b) have a first capillary through-hole (133b), a channel is formed between any two adjacent support bodies (133c), and at least a part of a projection of the first capillary through-hole (133b) in a thickness direction of the capillary through-hole layer (133a) falls between the two adjacent support bodies (133c).

4. The vapor chamber (13) according to claim 3, wherein
the first polymer material layer (132b) comprises a first base layer (132h) and a plurality of first protrusion parts (132i), and the plurality of first protrusion parts (132i) are all protruded on a side that is of the first base layer (132h) and that faces the first cover plate (131); and the first metal layer (132a) covers the first base layer (132h), and each support body (133c) wraps one of the first protrusion parts (132i).

5. The vapor chamber (13) according to claim 1 or 2, wherein
a plurality of first recess parts (132j) are disposed on a side that is of the second cover plate (132) and that is away from the first cover plate (131), each first recess part (132j) recesses toward the first cover plate (131), a part that is of the first metal layer (132a) and that is located in each first recess part (132j) serves as one support body (133c), a channel is formed between any two adjacent support bodies (133c), and each support body (133c) is connected to the capillary layer (133); and
a plurality of capillary through-holes (133b) are disposed on the capillary layer (133), the plurality of capillary through-holes (133b) have a first capillary through-hole (133b), and at least a part of a projection of the first capillary through-hole (133b) in a thickness direction of the capillary layer (133) falls between the two adjacent support bodies (133c).

6. The vapor chamber (13) according to claim 5, wherein
each first recess part (132j) is filled with a thermally conductive material (132m).

7. The vapor chamber (13) according to any one of claims 3 to 6, wherein
the plurality of capillary through-holes (133b) comprise a plurality of groups sequentially arranged in a first direction, each group comprises at least two capillary through-holes (133b) sequentially arranged in a second direction, and the first direction intersects the second direction; and
for any two adjacent groups, in the second direction, at least one capillary through-hole (133b) in another group is distributed between every two adjacent capillary through-holes (133b) in one group.

8. The vapor chamber (13) according to any one of claims 3 to 7, wherein
opening areas of at least two capillary through-holes (133b) in the plurality of capillary through-holes (133b) are different from each other.

9. The vapor chamber (13) according to any one of claims 3 to 8, wherein
at least one support body (133c) of the plurality of support bodies (133c) is of a columnar structure or a strip-shaped structure.

10. The vapor chamber (13) according to any one of claims 3 to 9, wherein
a plurality of first support bodies (133c) are disposed on the plurality of support bodies (133c), the plurality of first support bodies (133c) are sequentially arranged in the first direction, each first support body (133c) is of a strip-shaped structure extending in the second direction, and the first direction intersects the second direction.

11. The vapor chamber (13) according to claim 10, wherein
the plurality of first support bodies (133c) comprise a first group (S1) and a second group (S2), the first group (S1) and the second group (S2) are adjacent and arranged in the first direction, and each of the first group (S1) and the second group (S2) comprises at least two first support bodies (133c) sequentially arranged in the second direction; and
a projection of a gap between any two adjacent first support bodies (133c) in the first group (S1) in the first direction falls on one first support body (133c) in the second group (S2).

12. The vapor chamber (13) according to any one of claims 1 to 11, wherein
the second cover plate (132) further comprises a second metal layer (132c), the first metal layer (132a), the first polymer material layer (132b), and the second metal layer (132c) are sequentially stacked, the second metal layer (132c) is connected to the first polymer material layer (132b), and a surface roughness Rz of a surface (132e) that is of the second metal layer (132c) and that is connected to the first polymer material layer (132b) ∈ [0.5 µm, 5 µm].

13. The vapor chamber (13) according to any one of claims 1 to 12, wherein
the first cover plate (131) comprises a working region (131g), and the working region (131g) participates in enclosing the cavity (13c); and
the working region (131g) comprises a plurality of second protrusion parts (131h) and a plurality of second recess parts (1311), the plurality of second protrusion parts (131h) and the plurality of second recess parts (131i) are staggered, and a plurality of second protrusion parts (131h) are disposed around each second recess part (1311); each second protrusion part (131h) protrudes in a direction away from the second cover plate (132); and each second recess part (1311) recesses toward the second cover plate (132) and is connected to the capillary layer (133).

14. The vapor chamber (13) according to any one of claims 1 to 12, wherein
the first cover plate (131) comprises a working region (131g), and the working region (131g) participates in enclosing the cavity (13c); and
the working region (131g) comprises a second base layer (131j) and a plurality of third protrusion parts (131k), and the plurality of third protrusion parts (131k) are all protruded on a side that is of the second base layer (131j) and that faces the second cover plate (132), and are all connected to the capillary layer (133).

15. The vapor chamber (13) according to any one of claims 1 to 13, wherein
the first cover plate (131) comprises a third metal layer (131a), and the third metal layer (131a) is connected to the first metal layer (132a).

16. The vapor chamber (13) according to claim 15, wherein
the first cover plate (131) further comprises a second polymer material layer (131b) connected to the third metal layer (131a), the second polymer material layer (131b), the third metal layer (131a), and the first metal layer (132a) are sequentially stacked, and a surface roughness Rz of a surface (131d) that is of the third metal layer (131a) and that is connected to the second polymer material layer (131b) ∈ [0.5 µm, 5 µm].

17. The vapor chamber (13) according to claim 16, wherein
the first cover plate (131) further comprises a fourth metal layer (131c), the fourth metal layer (131c), the second polymer material layer (131b), and the third metal layer (131a) are sequentially stacked, the fourth metal layer (131c) is connected to the second polymer material layer (131b), and a surface roughness Rz of a surface (131e) that is of the fourth metal layer (131c) and that is connected to the second polymer material layer (131b) ∈ [0.5 µm, 5 µm].

18. The vapor chamber (13) according to any one of claims 1 to 17, wherein
a material of the polymer material layer in the vapor chamber comprises polyimide, polypropylene, polytetrafluoroethylene, polyethylene terephthalate, polyethylene naphthalate, polydimethylsiloxane, polyethylene, polypropylene carbonate, polyvinyl chloride, polyvinylidene chloride, polystyrene, or polyamide.

19. The vapor chamber (13) according to any one of claims 1 to 18, wherein
a glass temperature of the polymer material layer in the vapor chamber is greater than or equal to 320°C.

20. An electronic device (1), comprising
a housing (12) and the vapor chamber (13) according to any one of claims 1 to 19, wherein the vapor chamber (13) is located in the housing (12).
